# EUROPEAN PATENT SPECIFICATION

(11) **EP 1 502 350 B1**
(45) Date of publication and mention of the grant of the patent: **29.04.2009**
(21) Application number: 02781515.8
(22) Date of filing: 13.11.2002
(51) Int. Cl.: H03C 1/52

(54) **FREQUENCY MODULATOR USING SWITCHED CAPACITORS**
FREQUENZMODULATOR UNTER VERWENDUNG GESCHALTETER KAPAZITÄTEN
DISPOSITIF COMPRENANT UN CIRCUIT POURVU DE MOYENS DE REGLAGE SERVANT A REGLER AU MOINS UNE VALEUR DE SIGNAL CARACTERISTIQUE D'UN SIGNAL MODULE

(30) Priority: 30.11.2001 EP 01000687
(43) Date of publication of application: 02.02.2005
(73) Proprietor: NXP B.V., 5656 AG Eindhoven (NL)
(72) Inventor: RAGGAM, Peter, NL-5656 AA Eindhoven (NL); KOLLER, Manfred, NL-5656 AA Eindhoven (NL)
(74) Representative: Röggla, Harald
(86) International application number: PCT/IB2002/004775
(87) International publication number: WO 2003/047088

(56) References cited:
- EP-A- 0 725 478
- EP-A- 0 841 754
- US-A- 4 580 111
- US-A- 5 053 723
- US-A- 5 182 528
- US-A1- 2001 020 875
- US-B1- 6 181 215
- US-B1- 6 236 284

## Description

The invention relates to a device with a circuit for generating a modulated signal, with which circuit modulation means are implemented which are designed to receive a data signal and generate the modulated signal as a function of the data signal, where for the purpose of generating the modulated signal as a function of the received data signal a choice can be made between at least two characteristic signal values of the modulated signal.

The invention also relates to a circuit for generating a modulated signal with which circuit modulation means are implemented which are designed to receive a data signal and generate the modulated signal as a function of the data signal, where for the purpose of generating the modulated signal as a function of the data signal received, a choice can be made between at least two characteristic signal values of the modulated signal.

Such a device of the generic type described in the first paragraph with such a circuit of the generic type described in the second paragraph, which has a UHF transmitter type reference U2741B by the company "AMTEL WIRELESS & µC" has been sold in connection with a remote control device for remote controlled unlocking of a vehicle door and is therefore known.

The known device is designed to emit control information using a modulated signal. To this end modulation means are provided. To the modulation means can be supplied a data signal representing the control information, representing at least one data word consisting of bits. To generate the modulated signal the modulation means can as a function of the data signal choose between two characteristic signal values of the modulated signal, where at least one of the characteristic signal values is determined by at least two components connected to the circuit.

In the known device the problem arises that the at least one characteristic signal value determined by the at least one component connected to the circuit is determined by a fixed preset component value of this component and consequently can be generated only with relatively low precision because the characteristic signal value is unfavorably influenced by component tolerances of this component and also by component tolerances of the circuit which are difficult to determine in advance and which define the characteristic signal value of the modulated signal. There is also the disadvantage that this unfavorable influencing of the characteristic signal value of the modulated signal cannot be countered after production of the known device, whereby difficulties can sometimes arise on demodulation of the modulated signal with a receiver device for the modulated signal. The problem also exists that this unfavorable influencing of the characteristic signal value of the modulated signal could be countered exclusively in production of the device by suitable selection of the at least two components and by complex and expensive production steps in production of the circuit, whereby the cost of the known device would increase considerably.

US 2001/0020875 A1 discloses a phase locked loop (PLL) circuit that uses a voltage-controlled oscillator (VCO). The PLL circuit functions to generate an output frequency fo that is locked in phase with a precision reference signal fᵣ. The PLL circuit is a negative feedback system. A low frequency component which is output by a multiplier contains information related to a difference in phase between the reference signal fᵣ and the output f₀ of the VCO as divided down by a divide-by-M circuit. This phase error signal is filtered and used as the tuning voltage Vₜᵤₙₑ to control the frequency produced by the VCO. When the VCO is used in a Bluetooth radio communication, spectrum spreading in Bluetooth is accomplished in 79 frequency channel hops displaced by 1 MHz per frequency channel. By changing the value of M in the divide-by-M circuit, the VCO generates multiple output channels separated by the 1 MHz reference frequency.

It is an object of the invention to create a device of the type stated in the first paragraph and with a circuit of the type stated in the second paragraph to eliminate the above problems and create an improved device and an improved circuit.

To achieve the above object in a device of the type described in the first paragraph, it is provided according to the invention that adjustment means are provided which are designed to adjust programmably and as a function of the data signal at least one of the characteristic signal values.

To achieve the above object in a circuit of the type described in the second paragraph it is provided according to the invention that adjustment means are provided which are designed to adjust programmably and as a function of the data signal at least one of the characteristic signal values.

By the provision of the measures according to the invention it is advantageously achieved that at least one signal parameter of the modulated signal can be adjusted so that a negative influence on the precision of the at least one signal parameter due to component tolerances can be compensated practically in full. As a result furthermore the advantage is achieved that no selected and consequently expensive components need be provided. As a result the advantage is further achieved that no undesirably high cost is required in production of the circuit. As a result the further advantage is achieved that in a receiver device for the modulated signal, on demodulation of this signal no difficulties arise due to the at least one signal characteristic value.

In a solution according to the invention where the modulation means are achieved by frequency modulation means to generate a frequency-modulated signal forming the modulated signal and where with a circuit an oscillator stage is produced which is contained at least partly in the frequency modulation means and designed to generate the frequency-modulated signal variable in its frequency, and which oscillator stage has a capacitor configuration designed to establish at least two frequencies of the frequency-modulated signal, and which oscillator means has switch means which as a function of the data signal are designed to switch the capacitor configuration for the purpose of selecting one of the at least two frequencies, it has further proved advantageous if the adjustment means are designed to adjust programmably and as a function of the data signal the at least two frequencies of the frequency-modulated signal. This gives the advantage that at least two frequencies of the frequency-modulated signal are adjustable so that a negative influence on the precision of the frequency concerned caused by component tolerances can be compensated practically completely.

In a solution according to the invention it has further proved advantageous if the capacitor configuration has a multiplicity of capacitors and if the switching means has a multiplicity of switches, where at least one capacitor is allocated to each switch and where the multiplicity of capacitors and the multiplicity of switches form components of the adjustment means, and control means are provided using which, for the purpose of adjusting the at least two frequencies of the frequency-modulated signal, the switch can be controlled programmably and as a function of the data signal in relation to its switch state. This gives the advantage that utilizing a single capacitor configuration the at least two frequencies of the frequency-modulated signal are adjustable with high precision due to the multiplicity of capacitors and the multiplicity of switches. In connection with the single capacitor configuration it has further proved particularly advantageous to control the switches in relation to their switch state by means of the control means as a function of the data signal and also programmably because this ensures that each of the at least two frequencies can be adjusted reliably and above all reproducibly.

In a solution according to the invention it has further proved advantageous if the control means have a data source provided to emit at least two adjustment data words to influence the switches in relation to their switch state and if the control means have adjustment data word selection means which are designed to select as a function of the data signal one of the at least two adjustment data words which can be emitted by the data source. This gives the advantage that the correct adjustment data word for influencing the switch in relation to its switch state is available reliably in relation to the content of the data signal. The advantage is also achieved that adjustment can be performed on a purely digital basis.

In a solution according to the invention it can be provided that the at least two adjustment data words can be supplied directly to the switches. This is advantageous if each bit of the adjustment data words is allocated to a switch. It has however proved particularly advantageous if the control means have a decoding stage designed to receive an adjustment data word and decode the received adjustment word and to control the switch in relation to its switch state in accordance with the decoded adjustment data word. This gives the advantage that the adjustment data word concerned can have a number of bits which is less than the number of switches. This further gives the advantage that adaptation between a coding of an adjustment data word and a physical effect of the capacitor configuration can be performed when establishing the at least two frequencies.

In a solution according to the invention it has further proved advantageous if adjustment data storage means are provided which are intended to store at least one adjustment data word. This gives the advantage that at least one adjustment data word, following a test of the frequency modulation means in relation to the accuracy of at least one frequency allocated to this adjustment data word, can be adapted to the test result and hence individual adjustment of the at least one frequency is possible for each device or circuit.

In a solution according to the invention it is also proved advantageous if the multiplicity of capacitors is divided into at least two capacitor groups and if all capacitors of a capacitor group are identical in relation to capacitance. This gives the advantage that as a function of a number of capacitors activated by means of the switch, a linear adjustment range can be implemented for the at least two frequencies so that control of the switch in relation to its switch states can be achieved as simply as possible.

In a solution according to the invention where the modulation means are implemented by amplitude modulation means to generate an amplitude-modulated signal forming the modulated signal utilizing a carrier signal and where with the circuit amplitude definition means are implemented which are contained partly in the amplitude modulation means and designed to define at least two amplitudes of the amplitude-modulated signal, and which amplitude modulation means have controllable current conduction means which are provided to influence as a function of the data signal the amplitude definition means for the purpose of selecting one of the at least two amplitudes, it has further proved advantageous if the adjustment means are designed to adjust programmably and as a function of the data signal at least one amplitude of the amplitude-modulated signal. This gives the advantage that at least one amplitude of the amplitude-modulated signal is adjustable, so that a negative influence caused by component tolerances on the precision of the at least one amplitude can be compensated practically in full.

In a solution according to the invention it has further proved advantageous if the amplitude definition means can be implemented using the controllable current conduction means and if the controllable current conduction means has a multiplicity of current conduction stages, where a current is allocated to each current conduction stage in its conduction state, and where the multiplicity of current conduction stages form components of the adjustment means, and if control means are provided using which for the purpose of adjusting the at least one amplitude of the amplitude-modulated signal, the current conduction stages can be controlled programmably and as a function of the data signal in relation to their conduction state. This achieves the advantage that utilizing the controllable current conduction means to achieve the amplitude definition means the at least one amplitude of the amplitude-modulated signal can be adjusted with high precision due to the multiplicity of current conduction stages. In connection with the current conduction stages it has also proved particularly advantageous to control the current conduction stages using the control means as a function of the data signal and also programmably in relation to their conduction state because this ensures that the at least one amplitude can be adjusted reliably and above all reproducibly.

In a solution according to the invention it has further proved advantageous if the control means have a data source which is provided to emit at least two adjustment data words to influence the current conduction stages in relation to their conduction state and if the control means have adjustment data word selection means which are designed to select as a function of the data signal one of the at least two adjustment data words which can be emitted by the data source. This gives the advantage that the correct adjustment data word to influence the current conduction stages in relation to their conduction state is available reliably in relation to the content of the data signal. This further gives the advantage that adjustment can be performed purely on a digital basis.

In a solution according to the invention it can be provided that the at least two adjustment data words can be supplied directly to the current conduction stages. This is advantageous if each bit of the adjustment data words is allocated to a current conduction stage. It has however proved particularly advantageous if the control means have a decoding stage which is designed to receive an adjustment data word and decode the received adjustment data word and control the current conduction stages in relation to their conduction state in accordance with the decoded adjustment data word. This gives the advantage that the adjustment data word concerned can have a number of bits which is less than the number of current conduction stages. This also gives the advantage that adaptation between a coding of an adjustment data word and a physical effect of the current conduction stages can be performed when defining the at least two amplitudes.

In a solution according to the invention it has further proved advantageous if adjustment data storage means are provided which are designed to store at least one adjustment data word. This gives the advantage that the at least one adjustment data word, following a test on the amplitude modulation means in relation to the precision of at least one of the amplitudes allocated to the adjustment data word, can be adapted to the result of this test and hence individual adjustment of the at least one amplitude is possible for each device or circuit.

In a solution according to the invention it can be provided that the current conduction means have identical conductance properties. It has however proved particularly advantageous if the multiplicity of current conduction stages is formed using transistors which have different conductance properties. This gives the advantage that the at least one amplitude can be adjusted both roughly and finely.

In a solution according to the invention it can be provided that the carrier signal is passed to the amplitude modulation means independently of the control means. It has however proved particularly advantageous if the control means have carrier signal transfer means intended to transfer the carrier signal to the current conduction stages and using which the current conduction stages can also be controlled in relation to their conduction stage as a function of the carrier signal. This gives the advantage that the carrier signal using the control means can be utilized purely digitally for the purpose of adjusting the at least one amplitude of the amplitude-modulated signal.

In a solution according to the invention it can be provided that the supply voltage for the carrier signal transfer means can be implemented using a battery voltage or a reference voltage. It has however proved particularly advantageous if supply voltage generating means for the transfer means are provided, which utilizing the carrier signal are intended to generate a supply voltage for the carrier signal transfer means. This gives the advantage that the current conduction stage can be controlled irrespective of the temperature of the circuit and irrespective of tolerances of the circuit production process, whereby the adjustment of the at least one amplitude of the amplitude-modulated signal can be performed free from these influences.

In a circuit according to the invention it has further proved advantageous if the circuit is implemented as an integrated circuit. This achieves the advantage that all components of the adjustment means can be produced in a uniform process technology and that a number of the components required or available to implement the adjustment means are determined no longer by the dimensions of the device, but by an integration density of components in connection with process technology for circuit production, whereby adjustment means can be implemented which are intended to adjust with high precision the at least one characteristic signal value. This is particularly important in connection with the programmable adjustment as in purely programming terms the precision which can actually be achieved is determined finally by the number of available components of the adjustment means.

The invention will be further described with reference to examples of embodiment shown in the drawings to which however the invention is not restricted.
Fig. 1 shows diagrammatically in the form of a block circuit diagram a device fitted with frequency modulation means according to a first embodiment example of the invention.
Fig. 2 shows diagrammatically a capacitor configuration and circuit means which form the parts of the frequency modulation means of the device according to Fig. 1.
Fig. 3 shows in the form of a diagram schematically a functional connection between the frequency of a signal which can be generated using the device according to Fig. 1 and a value of a load capacity which can be achieved using the capacitor configuration according to Fig. 2 for a crystal resonator.
Fig. 4 shows in a similar manner to Fig. 3 a functional connection between the frequency of a signal which can be generated using the device according to Fig. 1 and a number of capacitor pairs used to achieve the load capacity for the capacitor configuration according to Fig. 2.
Fig. 5 shows in a similar manner to Fig. 1 a device according to a second example embodiment of the invention.
Fig. 6 shows in a similar manner to Fig. 1 a device fitted with amplitude modulation means according to a third embodiment example of the invention.
Fig. 7 shows in a similar manner to Fig. 6 a device according to a fourth embodiment example of the invention.
Fig. 8 shows diagrammatically a detail of the device according to Fig. 7.
Fig. 9 shows in a similar manner to Fig. 6 a device according to a fifth embodiment example of the invention.
Fig. 10 shows in the form of a table an adjustment of four amplitudes, which can be generated using the amplitude modulation means of the device according to Fig. 6, of an amplitude-modulated signal using four adjustment data words each with four bits.
Fig. 11 shows in a similar manner to Fig. 10 a grouping in relation to the power of the amplitude-modulated signal of the four adjusted amplitudes of the amplitude-modulated signal which can be generated using amplitude modulation means of the device according to Fig. 6 with the aid of two groups of adjustment data words.

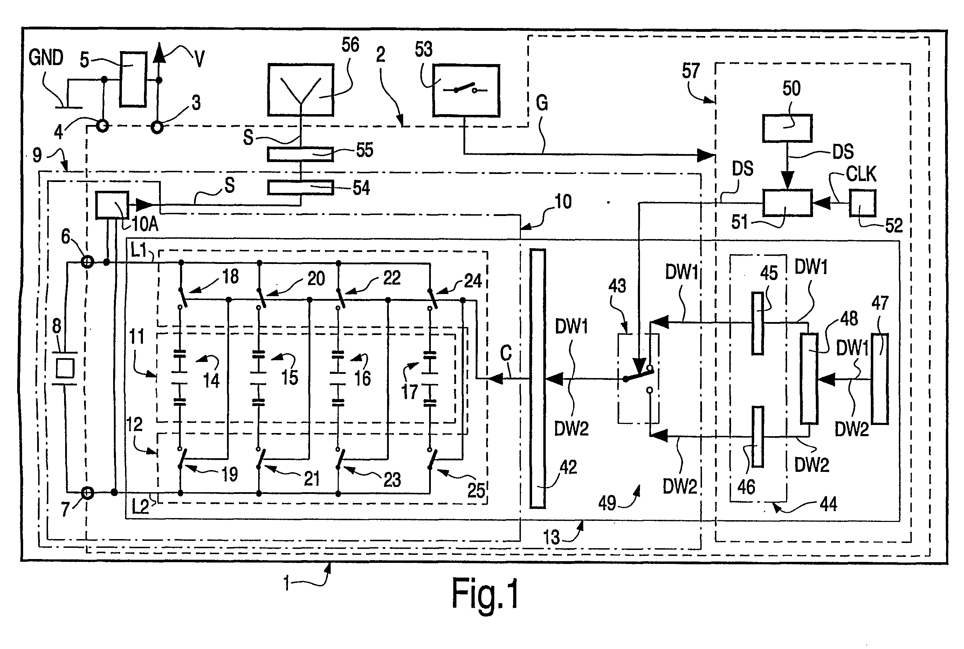

Fig. 1 shows a device 1 which implements a remote control device designed to emit control information using a frequency-modulated signal S, where the frequency-modulated signal S is defined by a frequency shifting between a first frequency F1 and a second frequency F2, which shifting is known to the expert as a "frequency shift keying" or FSK for short.

The device 1 has an integrated electric circuit 2. The circuit 2 has a first connection 3 and a second connection 4 using which the circuit 2 can be connected with voltage supply means 5 which in the present case are implemented by means of a battery and intended to provide a supply voltage V required for operation of circuit 2 in relation to a reference potential GND. It may, however, be stated that the voltage supply means 5 may also be implemented using a solar cell configuration.

The circuit 2 also has a third connection 6 and a fourth connection 7 using which the circuit 2 can be connected with a crystal resonator 8.

With the circuit 2 frequency modulation means 9 are implemented which are designed to receive a data signal DS representing control information to be emitted and to generate the frequency-modulated signal S as a function of the data signal DS.

With the circuit 2 is also implemented an oscillator stage 10 forming a component of the frequency modulation means 9 and designed to generate the frequency-modulated signal S variable in relation to its frequency. The oscillator stage 10 has an oscillator circuit 10A which is connected with the third connection 6 and the fourth connection 7 and using which the frequency-modulated signal S can be generated utilizing the oscillation properties of the crystal resonator 8 and utilizing a variable load capacity for the crystal resonator 8. For the purpose of implementing the load capacity the oscillator stage 10 has a capacitor configuration 11 designed to establish the first frequency F1 and the second frequency F2 of the frequency-modulated signal S. The oscillator stage 10 also has switch means 12 provided for switching the capacitor configuration as a function of the data signal S for the purpose of selecting one of the two frequencies F1 or F2.

According to the invention the device 1 also has adjustment means 13 which are designed to adjust programmably and as a function of data signal DS the two frequencies F1 and F2 of the frequency-modulated signal S. The capacitor configuration 11 and the switch means 12 form components of the adjustment means 13 which are described in more detail below.

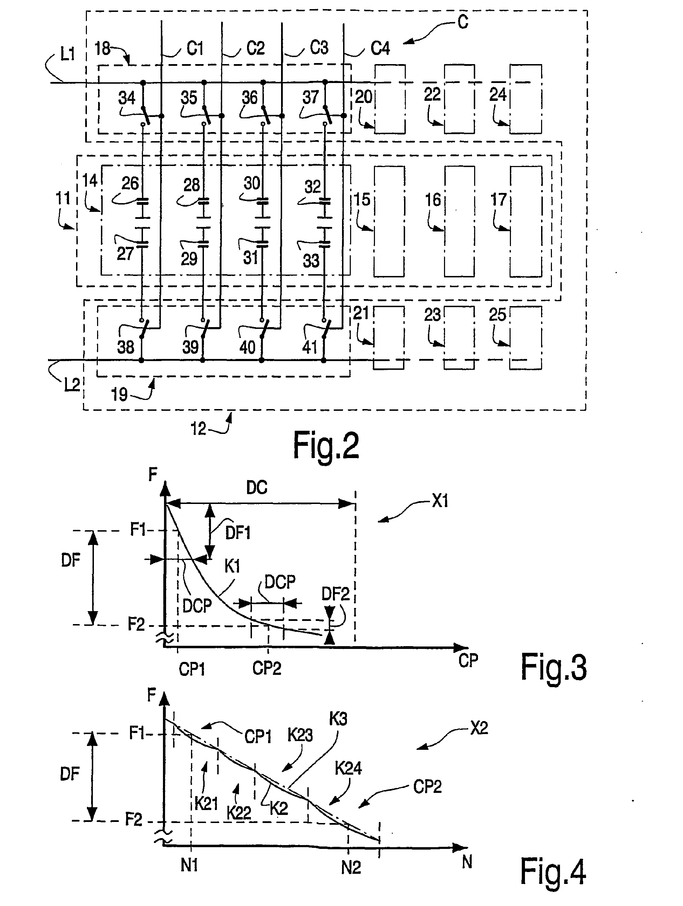

The capacitor configuration 11 has a first capacitor group 14, a second capacitor group 15, a third capacitor group 16 and a fourth capacitor group 17. For each of the four capacitor groups 14, 15, 16 and 17, one capacitor pair is shown representative of a multiplicity of capacitors of each capacitor group 14, 15, 16 and 17. The switch means 12 have a first switch group 18, a second switch group 19, a third switch group 20, a fourth switch group 21, a fifth switch group 22, a sixth switch group 23, a seventh switch group 24 and an eighth switch group 25. For each of the eight switch groups 18 to 25 one switch is shown representative of a multiplicity of switches, where one capacitor of the capacitor configuration 11 is allocated to each switch. Control signals C can be supplied to the switch means 12, using which signals the switches of the switch means 12 allocated to the capacitor groups 14, 15, 16 and 17 can be controlled in pairs in relation to their switch state, which is described in more detail below with reference to Fig. 2.

With reference to Fig. 2 the structure and function of the capacitor configuration 11 and switch means 12 are explained below. Fig. 2 shows in detail the first switch group 18, the second switch group 19 and the first capacitor group 14 and a circuit arrangement of the two switch groups 18 and 19 in connection with the first capacitor group 14. The remaining switch groups 20 to 25 and the remaining capacitor groups 15 to 17 are shown diagrammatically as blocks edged in dotted lines as their design and circuit arrangement are similar to the design and circuit arrangement of the two switch groups 18 and 19 and the first capacitor group 14 respectively.

The first capacitor group 14 has eight (8) capacitors 26 to 33 each of which is connected with the reference potential GND and are identical in relation to capacitance. In the present case each of the capacitors 26 to 33 of the first capacitor group 14 has a capacitance of 0.16 pico-Farad (pF). Each of the capacitors of the second capacitor group 15 has a capacitance of 0.26 pF. Each of the capacitors of the third capacitor group 16 has a capacitance of 0.57 pF. Each of the capacitors of the fourth capacitor group 17 has a capacitance of 1.54 pF.

The first switch group 18 has a first switch 34, a second switch 35, a third switch 36 and a fourth switch 37, where each switch 34 to 37 is connected with one of the capacitors 26, 28, 30 or 32. The second switch group 19 has a fifth switch 38, a sixth switch 39, a seventh switch 40 and an eighth switch 41, where each switch 38 to 41 is connected with one of the capacitors 27, 29, 31 or 33. Each switch 34 to 37 is connected via a connection L1 with the third connection 6 of the circuit 2. Each of the switches 38 to 41 is connected via a second connection L2 with the fourth connection 7 of the circuit 2. Control signals C for switches 34 to 41 can be supplied to the first switch group 18 and the second switch group 19, where a first control signal C1 pairs together functionally the first switch 34 and the fifth switch 38 and a second control signal C2 pairs together functionally the second switch 35 and the sixth switch 39 and where a third control signal C3 pairs together functionally the third switch 36 and the seventh switch 40 and where a fourth control signal C4 pairs together functionally the fourth switch 37 and the eighth switch 41. Consequently the first capacitor 26 and the second capacitor 27 can be switched in pairs, as a function of the first control signal C1 via the first switch 34 and the fifth switch 38, to the crystal resonator 8 or away from the crystal resonator 8. The same applies for the remaining capacitors 28 to 33 of the first capacitor group 14 and for the multiplicity of capacitors of the capacitor groups 15 to 17 and the multiplicity of switches of switch groups 20 to 25, where for each further pair of the multiplicity of switches of these switch groups 20 to 25 is provided a further control signal. A total capacitance of the multiplicity of capacitors of capacitor configuration 11 actually switched to crystal resonator 8 defines the relevant value of the modifiable load capacity for the crystal resonator 8, whereby the relevant one of the two frequencies F1 or F2 of the frequency-modulated signal S can be defined precisely. The multiplicity of capacitors of capacitor configuration 11 and the multiplicity of switches of switch means 12 are produced as a component of the integrated circuit 2, where the switch means are produced using field effect transistors. It should be stated that as a function of a production process of circuit 2, switch means 12 produced in a different way can be provided, as can be the case for example using bipolar transistors or MOS field effect transistors. It should further be stated that the precision of establishing the two frequencies F1 and F2 can be influenced by the number of switches and the number of capacitors.

Fig. 3 using a first diagram X1 shows a strongly non-linear functional correlation K1 between the frequency F of signal S which can be generated using oscillator stage 10 and the modifiable load capacitance CP implemented using the capacitor configuration 11. In the first diagram X1 the vertical axis shows the two frequencies F1 and F2 provided to emit the control information. The first diagram X1 further shows on the horizontal axis the load capacitances CP1 and CP2 corresponding to the respective frequencies F1 and F2 and dependent on component tolerances of the device 1. Using the first diagram X1 it is clear that with a symmetrical variation DCP of the load capacitance CP about the first load capacitance CP1, a first frequency change DF1 is given. It is further clear that on a variation identical to variation DCP1 about the second load capacitance CP2, a second frequency change DF2 is given which in its amount is substantially smaller than the first frequency change DF1. Because of this situation it has proved particularly advantageous for the multiplicity of capacitors of the respective capacitor group 14 to 17 to provide identical group capacitances - as explained above in connection with Fig. 2 - as this gives the advantage that essentially a linear correlation can be created between the frequency F of signal S and a number N of capacitor pairs of capacitor configuration 11 connected to the crystal resonator 8, as is shown in Fig. 4.

Fig. 4 shows a second diagram X2 which shows an approximately linear functional correlation K2 between the frequency F of signal S which can be generated using oscillator stage 10 and the number N of capacitor pairs of capacitor configuration 11 to be switched to the crystal resonator 8. The second diagram X2 shows on the vertical axis the frequency F of signal S which can be generated using oscillator stage 10 and on the horizontal axis the number N of capacitor pairs of capacitor configuration 11 switched to the crystal resonator 8. The functional correlation K2 has four function sections K21, K22, K23 and K24, the gradient value of which is defined by the four capacitor groups 14 to 17 which differ in capacitance of the capacitors. For the expert in this context it is evident that the correlation K3 shown in Fig. 4 is valid only for a number of capacitors of capacitor configuration 11 converging towards a limit value.

In order to linearize as far as possible the functional connection K1, it is essential that in the function section K21 capacitors with the smallest available capacitance, i.e. capacitors of the first capacitor group 14, can be switched to or from the crystal resonator 8. In this connection it has also proved essential that in section K24 the capacitors with the greatest available capacitance, i.e. the capacitors of the fourth capacitor group 17, can be switched to or from the crystal resonator 8. The same also applies to sections K22 and K23 so that the second capacitor group 15 is allocated to section K22 and the third capacitor group 16 to section K23. The allocation of the individual capacitor groups 14, 15, 16 and 17 is achieved using control signal C. With this allocation a considerable contribution is made to the linearization of the strongly non-linear correlation K1. It can however also be provided that all capacitors of capacitor configuration 11 have an individual capacitance. This is indeed associated with substantial extra complexity in circuitry but gives the advantage that the correlation K2 can be optimized in relation to a uniform gradient value within the four function sections K21, K22, K23 and K24 as is shown in dotted lines K3 in Fig. 4.

In the first diagram X1 with reference DC is shown a maximum variation range of load capacitance CP which can be achieved using capacitor configuration 11, known in specialist circles as the pull-in range. In the first diagram X1 and second diagram X2, reference DF also indicates a frequency difference between the first frequency F1 and the second frequency F2, known in specialist circles as the frequency swing of the frequency shift or FSK swing.

The adjustment means 13 shown in Fig. 1 also have a decoding stage 42 designed to receive an adjustment data word DW1 or DW2 and decode the received adjustment data word and control switches 34 to 41 of the first switch group 18 and the second switch group 19 and control the switches of the remaining switch groups 20 to 25 in relation to their switching state in accordance with the decoded adjustment data word DW1 or DW2. Decoding stage 42 is designed such that when the relevant adjustment data word DW1 or DW2 represents value m starting from a number m of capacitor pairs of capacitor configuration 11 switched to the crystal resonator 8, on an increase in the value m represented by the adjustment data word DW1 or DW2 to the value n, the number (n - m) of capacitor pairs of capacitor configuration 11 can also be switched to the crystal resonator 8, on a reduction in the value m represented by the relevant data word DW1 or DW2 is reduced to the value n, the number (m - n) of capacitor pairs of capacitor configuration 11 can be switched away from crystal resonator 8, taking into account the allocation of capacitor groups 14, 15, 16 and 17 to the function sections K21, K22, K23 and K24 shown in Fig. 4. The decoding stage 42 is formed using a decoder implemented by a hard-wired logic circuit.

For the purpose of adjusting the two frequencies F1 and F2 the adjustment means 13 also have adjustment data word selection means 43 which are designed to select as a function of data signal DS one of the two adjustment data words DW1 or DW2. The adjustment data word selection means 43 are to this end designed to receive the two adjustment data words DW1 and DW2. Furthermore the adjustment data word selection means 43 are designed to receive a serial binary representation of data signal DS, where as a function of the binary states 1 or 0 forming the serial binary representation of data signal DS, the first adjustment data word DW or the second adjustment data word DW can be selected by switching by between the two adjustment data words DW1 and DW2. The switching means 43 are formed using a multiplexer implemented by a hard-wired logic circuit.

The adjustment data means 13 also have, for the purpose of adjusting the two frequencies F1 and F2, a data source 44 which is implemented using a first register 45 and a second register 46. The first register 45 is designed for temporary storage of the first adjustment data word DW1 for an operating period during which the circuit 2 is in is active operating mode, and to emit the first adjustment data word DW1 to the adjustment data word selection means 43 during this operating period. The second register 46 is also designed for temporary storage of the second adjustment data word DW2 and for emission of the second adjustment data word DW2 to the adjustment data word selection means 43 during the operating period. Consequently the data source 44 is provided for temporary storage and emission of the two adjustment data words DW1 and DW2 to influence the multiplicity of switches of switch means 12.

The adjustment means 13 also have adjustment data storage means 47 which are designed to store, irrespective of the operating period, the two adjustment data words DW1 and DW2.

The adjustment means 13 also have an adjustment data preparation stage 48 designed for preparation of the two adjustment data words DW1 and DW2 in the data source at the start of the operating period. To this end the adjustment data preparation stage 48 is designed to access the adjustment data storage means 47 and in this access to the adjustment data means storage means 47 to read the two adjustment data words DW1 and DW2 from the adjustment data storage means 47. The adjustment data preparation stage 48 is also designed to emit the read first adjustment data word DW1 to the first register 45 and to emit the read second adjustment data word DW2 to the second register 46.

The adjustment means 13 also have control means 49 which are formed from a decoding stage 42, the adjustment data word selection means 43, the data source 44, the adjustment data preparation stage 48 and the adjustment data storage means 47, and using which for the purpose of adjusting the two frequencies F1 and F2 of the frequency-modulated signal S, the switches of the switch means 12 can be controlled programmably, i.e. using the first adjustment data word DW1 and second adjustment data word DW2, and as a function of the data signal DS in relation to their switch state. This gives the advantage that both the first frequency F1 and the second frequency F2 of the frequency-modulated signal S can be adjusted using the adjustment data words DW1 and DW2 supplied to the decoding stage 42 as a function of the data signal DS utilizing the switch means 12 and the single capacitor configuration 11.

The circuit 2 also has data signal storage means 50 designed for storage and emission of the data signal DS representing the control information. Circuit 2 also has a parallel/serial conversion stage 51 designed to access the data signal storage means 11 and to read the data signal DS from the data signal storage means 50. The parallel/serial conversion stage 51 is also formed to receive a conversion cycle signal CLK and in synchrony with this conversion cycle signal CLK to convert the data signal DS present in parallel form and read from the data signal storage means 50 into the serial binary representation of the data signal DS, and to emit in cycle synchrony this serial binary representation of data signal DS to the adjustment data word selection means 43. Circuit 2 also has cycle signal generating means 52 designed to generate and emit the conversion cycle signal CLK to the parallel/serial conversion stage 51.

The device 1 has start means 53 designed to generate and emit a start signal G to circuit 2, with which signal G in circuit 2 can be started first with the help of the adjustment data preparation stage 48 the preparation of the first adjustment data word DW1 in the first register 45 and the second adjustment data word DW2 in the second register 46. Furthermore with start signal G in circuit 2 the generation of the conversion signal CLK can be started so that data signal DS can be read from the data signal storage means 50 and the data signal DS converted from parallel form to the serial binary representation of data signal DS and this representation of data signal DS emitted to the frequency modulation means 9 and consequently also the frequency-modulated signal S generated using frequency modulation means 9.

The circuit 2 also has a frequency multiplying stage 54 designed to receive the frequency-modulated signal S from the oscillator stage 10 and multiply the two frequencies F1 and F2 of this frequency-modulated signal S by a multiplication factor in order to transfer the relevant frequency F1 or F2 of the frequency-modulated signal S into a frequency band provided for transmission of signal S. The frequency multiplication stage 54 is formed with a phase-locked-loop circuit (PLL). Circuit 2 also has amplification means 55 designed to receive signal S and amplify signal S and emit the amplified signal S to transmitting means 56 of the device 1, by which transition means 56 the frequency-modulated signal S can be radiated as an electromagnetic wave. The transmission means 56 are implemented using an antenna configuration.

The data signal storage means 50, parallel/serial conversion stage 51, cycle generating means 52, adjustment data word selection means 43, data source 44, adjustment data preparation stage 48 and adjustment data storage means 47 are implemented via data processing means 57, where the data processing means 57 are formed in the present case by a microcomputer. The two registers 45 and 46 are implemented by means of output registers of the microcomputer. It can be stated that the data processing means 57 can also be formed by a hard-wired logic circuit.

The adjustment data preparation stage 48 and parallel/serial conversion stage 51 are implemented using software which can be processed via the microcomputer. The cycle generating means 52 are implemented using a timer of the microcomputer. The data signal storage means 50 are implemented using a ROM of the microcomputer.

In the present case the adjustment data words DW1 and DW2 are determined in a process step of the production process of the device as a result of a test measurement of the two frequencies F1 and F2 and stored in the adjustment data storage means 47 before production of the device 1. In the present case the adjustment data storage means 47 are implemented using a PROM programmable during the production process. It can however be stated that the adjustment data storage means 47 can also be implemented using an EEPROM. This is advantageous if the adjustment data words DW1 and DW2 are to be modifiable during operation of device 1, which is important for example if compensation for a temperature behavior of circuit 2 influencing the two frequencies F1 and F2 is required.

It may also be observed that the capacitor configuration 11 can have an additional pair of capacitors, where a first capacitor of this pair is hard-wired between the third connection 6 and the reference potential GND and where a second capacitor of this pair can be hard-wired between the fourth connection 7 and the reference potential GND so that using this additional pair of capacitors the base capacity of capacitor configuration 11 can be achieved.

It may also be observed that with unilateral operation of the crystal resonator 8 in which mode only the third connection 6 of the circuit 2 is implemented, as in this case the crystal resonator 8 is connected firstly with a third connection 6 and secondly with a reference potential GND, no capacitor pairs but individual capacitors of capacitor configuration 11 are provided to form the load capacity of the crystal resonator 8.

It may also be observed that the adjustment data word selection means 43 and the data source 44 and the adjustment data preparation stage 48 and the adjustment data storage means 47 can also be combined in hardware as a single storage means to store the two adjustment data words DW1 and DW2, where during the presence of a valid address for the purpose of addressing one of the two adjustment data words DW1 or DW2, the addressed adjustment data word DW2 or DW1 can be permanently emitted by the storage means. In this context it can also be stated that these storage means can have an address decoder which can be designed using the serial binary representation of the data signal DS to address the adjustment data word DW1 or DW2 concerned.

It may also be observed that the switch means 12 can also be implemented using transmission gates, where such a transmission gate essentially consists of a transistor configuration.

With reference to an application example for the device 1 according to Fig. 1, the function method of the device 1 is now explained below. According to this application example it is assumed that before conclusion of a production process for the device 1, a test measurement was performed to measure two frequencies F1' and F2' of the frequency-modulated signal S which can be generated using frequency modulation means 9. In this test measurement test control signal forming the control signals C were supplied to the switch means 12 and the frequencies F1' and F2' of signal S generated by the oscillator circuit 10A measured. As a result of analysis of this measurement with respect to deviation of the generated frequencies F1' and F2' from the two frequencies F1 and F2 specified for the emission of control information, generated and stored in the adjustment data means 47 were those adjustment data words DW1 and DW2 using which these component tolerances of the crystal resonator 8 or circuit 2 can be compensated so that the two provided frequencies F1 and F2 can be generated with the maximum precision.

According to this application example it is further assumed that device 1 forms a mobile remote control device with which a user of this device 1 can unlock a vehicle door remotely. Consequently the data signal storage means 50 contain the data signal DS which represents control information to unlock the vehicle door and which control information can be emitted by a transmission means 56 during the operating period as an electromagnetic wave to a receiver device of a vehicle. The receiver device with regard to the FSK swing of a receivable frequency-modulated signal S has narrow-band dimensioned receiving means, giving a high resistance to interference signals and a high sensitivity in relation to the receivability of the frequency-modulated signal S.

In the device 1, circuit 2 is first in sleep mode in which, for the purpose of maximum length of life, the energy consumption of circuit 2 has a minimum value. A user activates the start means 53 for the purpose of unlocking the vehicle door. In activating start means 53, which is reported to the circuit 2 and in particular data processing means 57 via a start signal G, the circuit 2 at the start of the operating period is set to an active operating mode.

In the active operating mode first the adjustment data preparation stage 48 reads the first adjustment data word DW1 to adjust the first frequency F1 from the adjustment data storage means 47 and provides this in the first register 45. Then the adjustment data preparation stage 48 reads the second adjustment data word DW2 from the adjustment data storage means 47 and provides this in the second register 46.

Thereupon in the cycle signal generating means 52 the generation of a conversion cycle signal CLK is activated. In the parallel/serial conversions stage 51 the reading of data signal DS then begins from the data signal storage means 50 and this read data signal DS is converted into the serial representation of data signal DS which is emitted as a bit sequence of logic values one (1) and naught (0) in cycle synchrony with the conversion cycle signal CLK to the adjustment data word selection means 43. The data signal DS in the present case consists of 16 bytes each of 8 bits.

In the adjustment data means selection means 43 depending on the logic value one (1) or naught (0) a selection is made between the first adjustment data word DW1 stored in register 45 and the second adjustment data word DW2 stored in the second register 46. The selected adjustment data word DW1 or DW2 is output to the decoding stage 42. In the decoding stage 42 the received adjustment data word DW1 or DW2 is decoded and according to this decoding the control signals C to control the multiplicity of switches in switch means 12 are output to switch means 12. According to the control signals C using the switch means 12 and capacitor configuration 11, when a first adjustment data word DW1 is present the first load capacitance CP1 of the load capacity for the crystal resonator 8 is implemented, whereby using the oscillator circuit 10A the signal S with the first adjusted frequency F1 is generated. According to the control signals C using the switch means 12 and the capacitor configuration 11, when the second adjustment data value DW2 is present the second load capacitance CP2 of the load capacity for the crystal resonator 8 is implemented, whereby using the oscillator circuit 10A the signal S with the second adjusted frequency F2 is generated. After the complete emission of the 16 bytes of the data signal DS, circuit 2 is returned to its sleep mode.

By the provision of the adjustment means according to the invention in the device 1, the advantage is obtained that the frequency-modulated signal S has two precisely adjusted frequencies F1 and F2 which can easily be received by the receiving means - dimensioned as narrow-band in relation to the FSK swing - of the receiving device of the vehicle. This gives the further advantage of guaranteeing a high resistance to interference in the transmission of control information from the device 1 to the receiver device and in the reception of the control information at the receiver device. The advantage is also achieved that in contrast to a frequency-modulated signal S with non-adjusted frequencies, the FSK swing can advantageously have a relatively low value as practically no account need be taken of a frequency tolerance band of the relevant frequencies F1 or F2.

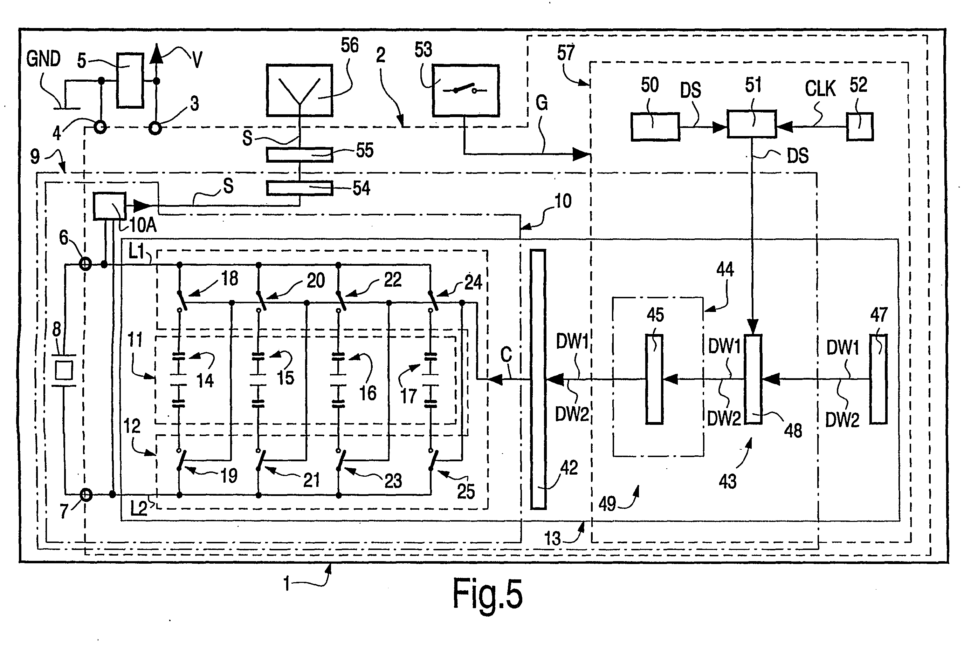

In the device 1 shown in Fig. 5 the frequency modulation means 9, in addition to oscillator stage 10 and decoding stage 42, also comprise the data source 44 and the adjustment data preparation stage 48. The data source 44 has a single register namely the first register 45 which is implemented using an output register of the microcomputer forming the data processing means 57. The first register 45 as a result of receiving the first adjustment data word DW1 during the operating period is designed for temporary storage and output of this first adjustment data word DW1 to the decoding stage 42. The first register 45 is also designed for receiving the second adjustment data word DW2 during the operating period and on receipt of the second adjustment data word DW2, for temporary storage and output of this second adjustment data word DW2 to the decoding stage 42.

The adjustment data preparation stage 48 in the present case is designed for dynamic preparation of the two adjustment data words DW1 and DW2. To this end the adjustment data preparation stage 48 is designed to receive the serial representation of data signal DS. The adjustment data preparation stage 48 is also designed, as a function of the binary value of the serial representation of data signal DS, to access the adjustment data storage means 47 where as a function of the binary value of the serial representation of data signal DS a selection can be made between the first adjustment data word DW1 and the second adjustment data word DW2. In this selection using the adjustment data preparation stage 48 the relevant adjustment data word DW1 or DW2 is read from the memory address of the PROM corresponding to the binary value of the serial representation of data signal DS. For the case that the binary value of the serial representation of data signal DS has the value naught (0), the adjustment data preparation stage 48 is designed to read the first adjustment data word DW1 and output the first adjustment data word DW1 to the single register 45. For the case where the binary value of the serial representation of data signal DS has the value one (1), the adjustment data preparation stage 48 is designed to read the second adjustment data word DW2 and output the second adjustment data word DW2 to the single register 45. Consequently in the present case the adjustment data preparation stage 48 forms the adjustment data selection means 43. The control means 49 in the present case are formed by the decoding stage 42, the data source 44, the adjustment data word selection means 43 and the adjustment data storage means 47.

In this context it may be emphasized in particular that the design of the device 1 according to Fig. 5 favors the adjustment of more than two frequencies as is advantageous for example with a quadrature FSK (QFSK). In this context it can further be stated that the parallel/serial conversion stage 51 can also be formed as a transcoding stage so that the data signal DS read from the data signal storage means 50 can be subjected to transcoding whereupon a transcoded representation of data signal DS can be output to the adjustment data preparation stage 48 from the transcoding state. The adjustment data word selection means 43 can then be designed to select one adjustment data word from a number of adjustment data words exceeding in particular the value of two (2).

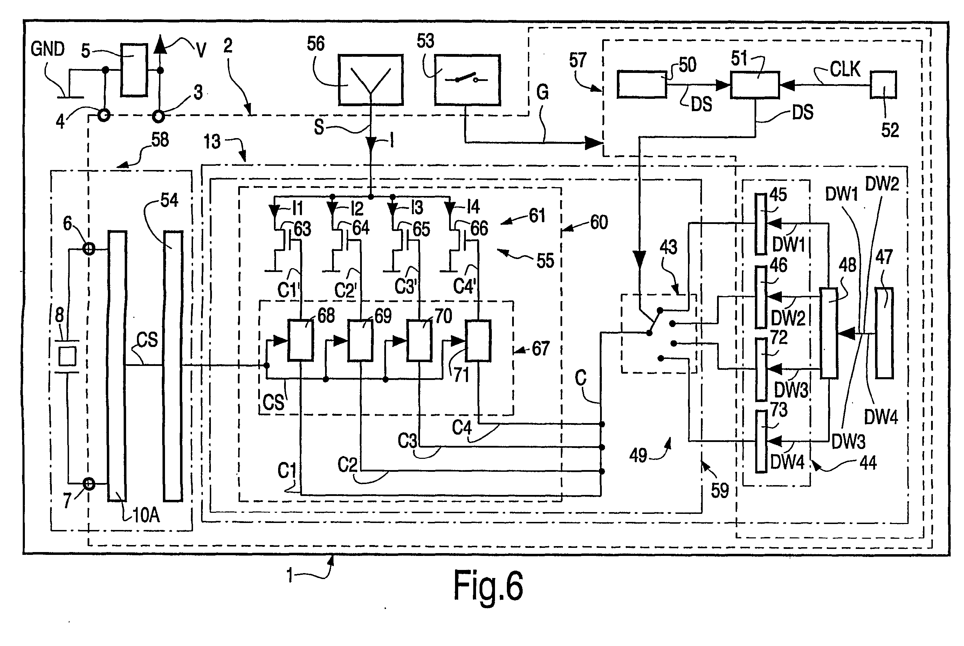

Fig. 6 shows a device 1 which implements a remote control device designed to emit control information using an amplitude-modulated signal S, where the amplitude-modulated signal S is defined by an amplitude shifting between four amplitudes A1 to A4, which shifting is known to the expert under the term "quadrature amplitude shift keying" or QASK for short.

The device 1 has carrier signal generating means 58 designed to generate a carrier signal CS. To this end the carrier signal generating means 58 contain the crystal resonator 8 and oscillator circuit 10A, from which circuit carrier signal CS can be output with a frequency of 13.56 MHz. The carrier signal generating means 58 also have frequency multiplier stage 54 using which the frequency of the carrier signal CS can be multiplied to a value of 868 MHz.

The circuit 2 implements amplitude modulation means 59 designed to receive the data signal DS and generate the amplitude-modulated signal S as a function of the data signal DS and utilizing the carrier signal CS, where for the purpose of generating the amplitude-modulated signal S as a function of the received data signal DS a selection can be made between the four amplitudes A1 to A4. To this end circuit 2 constitutes amplitude definition means 60 forming components of the amplitude modulation means 59, which amplitude definition means 60 are designed utilizing control signals C to establish the four amplitudes A1 to A4 of the amplitude-modulated signal S.

The amplitude definition means 60 have controllable current conduction means 61. The controllable current conduction means 61 are designed to generate a current I through the transmission means 56, where current I can be modified programmably as a function of data signal DS utilizing the control signals C. The multiplicity of current conduction stages 63 to 66 are formed by transistors with different conductance properties. The first current conduction stage 63 has a first current I1 allocated to it in its conducting state. Allocated to the second current conduction stage 64 in its conducting state is a second current I2. Allocated to the third current conduction stage 65 in its conducting state is a third current I3. Allocated to the fourth current conduction stage 66 in its conducting state is a fourth current I4. The four currents I1 to I4 are weighted binary to each other and the sum of the four currents I1 to I4 defines current 1. In the present case the transistors are implemented using field effect transistors which in relation to channel geometry differ from each other so that by means of these the binary weighted currents I1 to I4 can be generated. It should be stated that the current conduction stages 63 to 66 can also be implemented by other electrical components.

The amplitude definition means 60 also have carrier signal transfer means 67 designed to receive the carrier signal CS and supply the carrier signal CS to each of the current conduction stages 63 to 66. To this end the carrier signal transfer means 67 have a first carrier signal supply stage 68, a second carrier signal supply stage 69, a third carrier signal supply stage 70 and a fourth carrier signal supply stage 71. Each of the four carrier signal supply stages 68 to 71 is formed as a logic AND gate which has two inputs, where precisely one of the current conduction stages 63 to 66 is allocated to each AND gate. The carrier signal CS can be supplied to each first input of the carrier signal supply stages 68 to 71. The first control signal C1 can be supplied to the second input of the first carrier signal supply stage 66. The second control signal C2 can be supplied to the second input of the second carrier signal supply stage 69. The third control signal C3 can be supplied to the second input of the third carrier signal supply stage 70. The fourth control signal C4 can be supplied to the second input of the fourth carrier signal supply stage 71. According to its logic AND function, the first carrier signal supply stage 68 is designed, as a function of the frequency of the carrier signal CS, to modify the logic signal value of the first control signal C1 and output a modified first control signal C1' to the first current conduction stage 63. The second carrier signal supply stage 69 according to its logic AND function is designed, as a function of the frequency of the carrier signal CS, to modify the logic signal value of the second control signal C2 and output a modified second control signal C2' to the second current conduction stage 63. The third carrier signal supply stage 70 according to its logic AND function is designed, as a function of the frequency of the carrier signal CS, to modify the logic signal value of the third control signal C3 and output a modified third control signal C3' to the third current conduction stage 63. The fourth carrier signal supply stage 71 according to its logic AND function is designed, as a function of the frequency of the carrier signal CS, to modify the logic signal value of the fourth control signal C4 and output a modified fourth control signal C4' to the fourth current conduction stage 66. The modified control signals C1' to C4' always have a logic value 1 or 0 corresponding to the signal value of the carrier signal CS when the signal value of the respective control signal C1 to C4 has the logic value 1. The four modified control signals C1' to C4' can in the present case each be supplied to a gate connection of the field effect transistors implementing the current conduction stages 63 to 66, and if they represent the logic value 0, cause the transistor concerned to be controlled into its non-conductive state, and if they represent the logic value 1 cause the transistor concerned to be controlled into its conductive state. Consequently using the carrier signal transfer means 67 the four current conduction stages 63 to 66 can be controlled programmably as a function of the data signal CS and also as a function of the carrier signal CS in relation to their conduction state. The controllable current conduction means 61 constitute the amplification means 55 of the device 1 to which in the present case can be supplied the unmodulated carrier signal CS using the carrier signal transfer means 67. It should be stated here that the four carrier signal supply stages 67 can also be implemented using other logic functions, where depending on the implementation concerned inverting AND gates, OR gates or a combination of both gates can be used.

According to the invention device 1 also has adjustment means 13 which are designed to adjust programmably - in the present case using the first adjustment data word DW1 and the second adjustment data word DW2 and a third adjustment data word DW3 and a fourth adjustment data word DW4 - and as a function of the data signal DS the four amplitudes A1 to A4 of the amplitude-modulated signal S where the multiplicity of current conduction stages 63 to 66 form components of the adjustment means 13.

For the purpose of adjusting the four amplitudes A1 to A4, the adjustment means 13 also have adjustment data word selection means 43 which in the present case are designed to select as a function of the data signal DS one of the four adjustment data words DW1 to DW4. The four adjustment data words DW1, DW2, DW3 and DW4 each have four (4) bits. The first bit represents the first control signal C1 and the second bit represents the second control signal C2 and the third bit represents the third control signal C3 and the fourth bit represents the fourth control signal C4. The adjustment data word selection means 43 are designed to receive the data signal DS represented by the bit pairs and as a function of the binary value of these bit pairs to select one of the four adjustment data words DW1 to DW4. The adjustment data word selection means 43 are also designed to emit the selected adjustment data words DW1, DW2, DW3 or DW4 as the respective control signal C.

The parallel/serial converter stage 51 in the present case is designed to receive a parallel representation of the data signal DS from the data signal storage means 50 and for parallel/serial conversion of this parallel representation of the signal DS into a serial representation of data signal DS consisting of bit pairs and output these bit pairs to the adjustment data word selection means 43 in cycle synchrony to the conversion cycle signals CLK as serial bit pairs.

The device 1 also has adjustment data storage means 47 which in the present case are provided to store the four adjustment data words DW1 to DW4.

In the present case the adjustment data preparation stage 48, on the presence of start signal G is designed to access the adjustment data storage means 47 and read the four adjustment data words DW1 to DW4 from the adjustment data storage means 47 and prepare the four adjustment data words DW1 to DW4 in data source 44.

In the present case data source 44 is provided to output the four adjustment data words DW1 to DW4 to influence the current conduction stages 63 to 66 in relation to their conduction state and to this end has four registers 45, 46, 72 and 73.

The control means 49, using which in the present case, for the purpose of adjusting the four amplitudes to A1 to A4 of the amplitude-modulated signal S, the current conduction stages 63 to 66 are controllable programmably and as a function of the data signal DS in relation to their conduction state, contain the amplitude definition means 60, the adjustment data word selection means 43, the data source 44 and the adjustment data preparation stage 48.

For the sake of completeness it should be mentioned that the transmission means 56 have an inductance not shown in Fig. 6 switched between the amplitude definition means 60 and the connection 3. It should also be stated that an adapter stage not shown in Fig. 6 is provided to adapt an antenna impedance to an impedance suitable for the transmission means 56 and that the transmission means 56 have an antenna configuration connected to the adapter stage, which configuration has the antenna impedance.

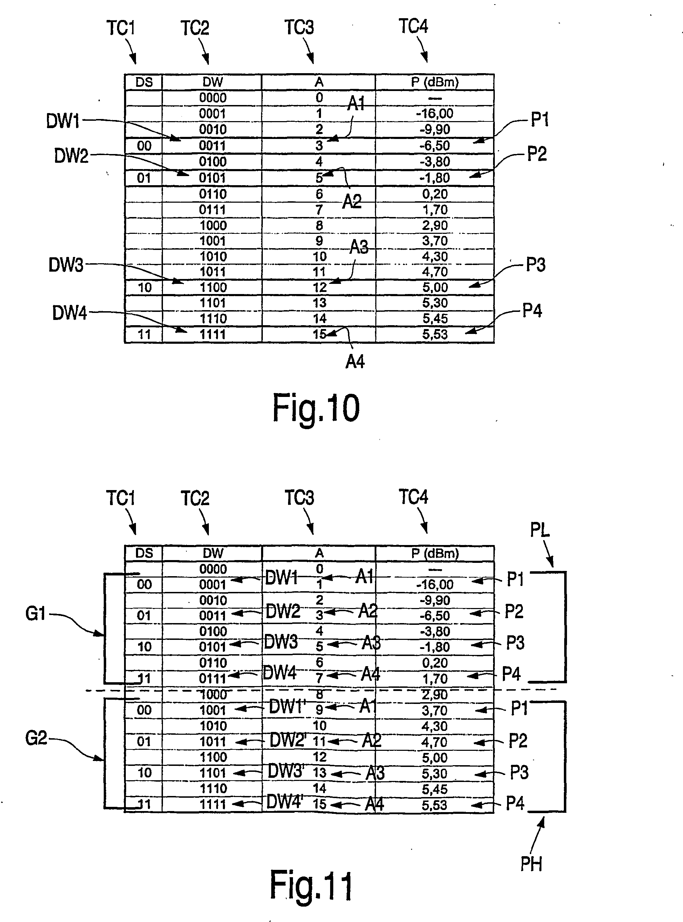

With reference to an application example for the device 1 according to Fig. 6 the working method of the device 1 is explained below. According to the application example it is assumed that before completion of a production process for the device 1 a test measurement was performed of the amplitude-modulated signal S which can be generated with amplitude modulation means 59 and that suitably four data words DW1 to DW4 to adjust the four amplitudes A1 to A4 were determined and stored in the adjustment data storage means 47. This situation is explained below with reference to Fig. 10.

Fig. 10 shows a table which has a first column TC1, a second column TC2, a third column TC3 and a fourth column TC4. The first column TC1 shows the representation of data signal DS in bit pairs. The second column TC2 lists in binary form sixteen (16) available data words DW. The third column TC3 lists dimensionlessly the amplitudes A of current I which correspond to the available data words DW. The fourth column TC4 lists the power P of the amplitude-modulated signal S which can be emitted by the transmission means in decibels in relation to one (1) milliwatt (dBm). Fig. 10 also shows the data words DW found as a result of the test measurement and marked as the four adjustment data words DW1, DW2, DW3 and DW4, using which on selection of the relevant adjustment data word DW1 to DW4 by means of the selection means 43, one of the four amplitudes A1 to A4 of current I can be generated whereby an amplitude-modulated signal S can be emitted by the transmission means 56 when a user of the device activates the start means G.

It may be observed that the start means 53 of the device 1 according to the invention can be designed to emit a first start signal G1 and a second start signal G2. It can also be provided that the adjustment data storage means 47 can store two sets of adjustment data words DW1 to DW4 and DW1' to DW4' and that the adjustment data preparation stage 48 is designed on occurrence of the first start signal G1 to prepare the first set of adjustment data words DW1 and DW4 and on occurrence of the second start signal G2 to prepare the second set of adjustment data words DW1' to DW4'. This situation is explained below with reference to Fig. 11.

Fig. 11 shows in the form of a four-column table a grouping of adjustment data words DW1 to DW4 and the adjustment data words DW1' to DW4' implemented in relation to both start signals G1 and G2. The consequence of this grouping is that the amplitude-modulated signal S is allocated with regard to power P to a low power range PL or to a high power range PH. This advantageously achieves that the amplitude-modulated signal S can be used both for a small spread and for a large spread or for different application cases and that despite this the adjustment of the four amplitudes A1 to A4 of the amplitude-modulated signal S can be performed using the two groups of adjustment data words DW1 to DW4 or DW1' to DW4'. A suitable application for this is for example given when with one and the same device 1 a vehicle door of a vehicle is to be unlocked and a park heater of this vehicle activated. For unlocking the vehicle door usually an amplitude-modulated signal S of the low power range PL is used as this unlocking is normally performed when a user of the vehicle is in the immediate vicinity of the vehicle. To activate the park heater of the vehicle usually an amplitude-modulated signal S from the high power range PH is used as this activation of park heating is normally performed by a user when he is at a greater distance from the vehicle - for example in his house - and activates the park heating from there. This situation is of interest in particular when the short term use of the device 1 in the high power range PH is permitted by regulations. In this context it should be stated that more than two groups of adjustment data words can also be provided if the number of adjustment data words or the grouping method allows this.

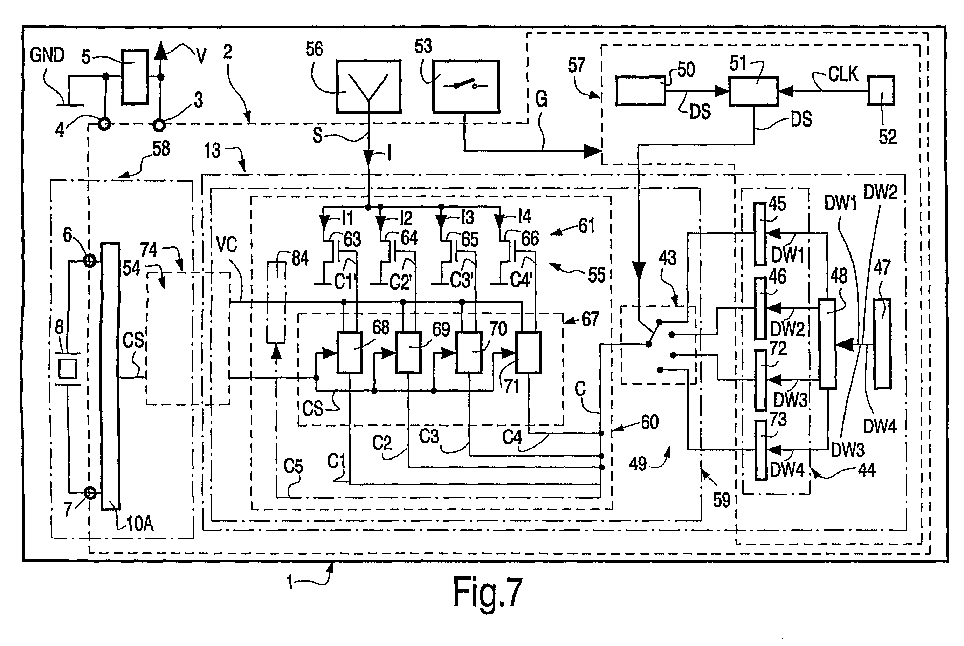

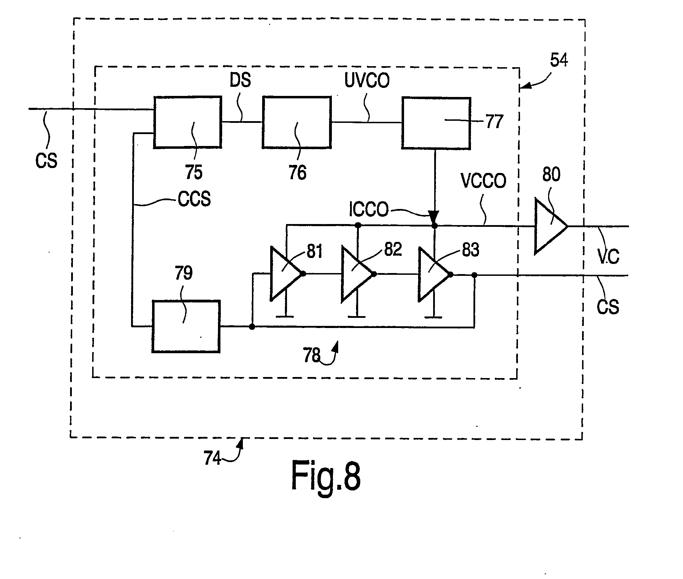

The device shown in Fig. 7 has voltage supply means 74 which are formed utilizing the carrier signal CS to generate a voltage supply VC for the carrier signal transfer means 67. The voltage supply means 74 for the transfer means are explained below with reference to Fig. 8.

The voltage supply generating means 74 for the transfer means shown in detail in Fig. 8 have a phase/frequency detector stage 75, a loop filter stage 76, a voltage/current conversion stage 77, a current-controlled ring oscillator stage 78, a frequency divider stage 79 and an impedance conversion stage 80.

The phase/frequency detector stage 75 can be supplied firstly with the carrier signal CS which can be emitted by oscillator circuit 10A and secondly with a comparison signal CCS which can be emitted by the frequency divider stage 79. The phase/frequency detector stage 75 is designed to detect a phase/frequency difference between the carrier signal CS and the comparison signal CCS and to generate and emit a detection signal DS representing this difference to the loop filter stage 76.

The loop filter stage 76 is designed for low pass filtration of the detection signal DS and to output the voltage control signal UVCO representing the filter detection signal DS to the voltage/current conversion stage 77.

The voltage/current conversion stage 77 is designed to convert the voltage control signal UVCO into a current control signal ICCO representing the voltage control signal UVCO and to output the current control signal ICCO to the current-controlled ring oscillator stage 78.

The current-controlled ring oscillator stage 78 has a first inverter circuit 81, a second inverter circuit 82 and a third inverter circuit 83 which are connected together in ring form as a series circuit and to which can be supplied the current control signal ICCO at its power supply connection so that in operation a ring oscillator stage voltage supply VCCO is present at these power supply connections which can be supplied via impedance converter stage 80 to the carrier signal transfer means 67. From the output of the third inverter circuit 83 the carrier signal CS with carrier frequency 868 MHz can be supplied to the carrier signal transfer means 67 and the frequency divider stage 69.

The frequency divider stage 79 is designed to divide the frequency of the carrier signal CS which can be generated by the ring oscillator stage 78, by the factor 64 whereby the comparison signal CCS can be generated which can be output via the frequency divider stage 79 at the phase/frequency detector stage 75. This ensures that there is a rigid frequency/phase ratio between the carrier signal CS generated by the oscillator stage 10A and the carrier signal CS output at the carrier signal transfer means 67. Stages 75 to 79 constitute the frequency multiplication stage 54.

By providing the current-controlled ring oscillator 78 and accessing the ring oscillator supply voltage VCCO set at the power supply connections of the inverter circuits 81 to 83, the advantage is achieved that a voltage supply VC for the carrier signal transfer means is obtained which is independent of the production process of all transistors of circuit 2 and the temperature of circuit 2 and which due to the rigid phase-frequency ratio automatically adapts its value to the quality of the transistors of circuit 2. In concrete terms this means that in the case of transistors of lower quality, a higher ring oscillator supply voltage VCCO is set than in the case of transistors of higher quality in order to achieve the rigid phase-frequency ratio. This automatic setting of the ring oscillator power supply VCCO also leads to a correlated adaptation of the signal level of the modified control signals C1' to C4' as this signal level is dependent on the voltage supply VC of the carrier signal transfer means. Thus for the carrier signal transfer means 67 it is ensured that the modified control signals C1' to C4' representing the logic value one (1) always have a signal level adapted to the respective quality of the transistors of circuit 2 forming the current conduction stages 63 to 66. Consequently the adjustment means 13 are advantageously designed additionally utilizing the carrier signal CS to adjust the four amplitudes A1 to A4.

In this context it should be stated that the adjustment means 13 can be designed to change programmably the voltage supply VC for the carrier signal transfer means. This is shown in Fig. 7 with the block 84 in dotted lines which constitutes a controllable modification stage designed to modify the voltage supply VC for the carrier signal transfer means and connected after the voltage supply means 74 for the transfer means. In this context it should be stated that the modification stage can be controlled using a fifth control signal C5 where the fifth control signal C5 can be generated for example also utilizing one of the bits of the data words DW1 to DW4 available in data source 44 - in particular if as would be necessary in the present case, a fifth bit is provided for this - or also a bit independent of data words DW1 to DW4. Using the modification stage it is advantageously achieved that programmably a grouped adjustment of the four amplitudes A1 to A4 of the amplitude-modulated signal S can be performed, whereby the grouping of power P of amplitude-modulated signal S in the high power range PH and low power range PL explained in connection with Fig. 11 can be implemented.

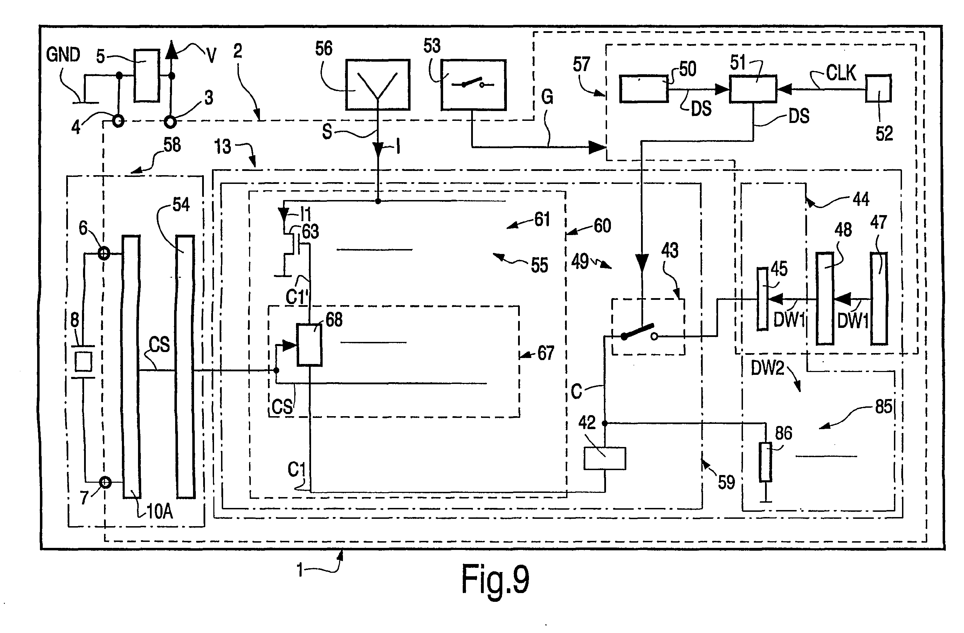

Fig. 9 shows a device 1 designed to emit control information using an amplitude-modulated signal S, where the amplitude-modulated signal S is defined by an amplitude shifting between two amplitudes A1 and A2 and where the second amplitude A2 has the value naught (0) which corresponds to an amplitude modulation with a modulation degree of 100%.

The device 1 has a multiplicity of two hundred and fifty-six (256) current conduction stages, for which multiplicity of current conduction stages the first stage 63 is shown representatively. The device 1 also has a multiplicity of two hundred and fifty-six (256) carrier signal transfer stages, for which multiplicity of carrier signal transfer stages the first stage 68 is shown representatively. Device 1 also has a group 85, provided to implement the second data word DW2, of eight (8) resistors for which group 85 of eight (8) resistors a first resistor 86 is shown representatively. In the present case the data source 44 is implemented using parts of data processing means 57 and using group 85 of eight (8) resistors. Corresponding to the eight (8) resistors, the first data word DW1 has eight (8) bits. The eight (8) resistors are each connected with reference potential GND. The eight (8) resistors are provided to load the control signal C against reference potential GND.

Using the adjustment data word selection means 43 in the present case a first data word DW1 can be selected where in this case the control signals C are determined by the first data word DW1 as the load on control signal C from eight (8) resistors is insignificant in this case due to the dimensioning of the eight (8) resistors. The adjustment data word selection means 43 are also designed for non-selection of the first data word DW1 where in this case the control signals C have the logic value naught (0) as the eight (8) resistors act as the second data word DW2 representing the logic value naught (0). In the present case the first data word DW1 serves the adjust the first amplitude A1 which represents the unmodulated case of the amplitude-modulated signal S. The second data word DW2 serves to generate a one hundred percent modulation of the amplitude of amplitude-modulated signal S, where all current conduction stages of current conduction means 61 can be controlled into their blocking state. In this context it should be stated that the group 85 of eight (8) resistors can be connected in any way with the supply voltage V or reference potential GND to implement the second data word DW2, whereby a modulation deviating from a one hundred percent modulation can be implemented.

The control means 49 also have a decoding stage 42 which in the present case is designed to receive the first adjustment data word DW1 and the second adjustment data word DW2 and control the multiplicity of current conduction stages in relation to their conduction state in accordance with the decoded adjustment data word DW1 or DW2.

It may be observed that in connection with the one hundred percent modulation of amplitude it can also be provided that the adjustment data word selection means 43 and the group 85 of eight (8) resistors can be implemented by a group of AND gates, to which can be supplied firstly at their first input the data signal and at their second input one bit of the first data word in each case.

Also in the present case if a low power consumption of circuit 2 is desired it can be provided that in an embodiment according to the invention advantageously eight (8) transistors weighted binary in relation to their conductivity and eight (8) carrier signal supply states can be provided, so the decoding stage 42 can be omitted.

It may be observed that the carrier frequency transfer means 67 can be included between the transmission means 56 and amplitude definition means 60. In this case the carrier frequency transfer means 67 can be implemented using a single transistor.

It may further be observed that in a device 1 adjustment means can be provided which are designed, programmably and as a function of the data signal DS, to adjust at least two frequencies and to adjust at least one amplitude of a modulated signal. This can be advantageous if for example a modulated signal is to be generated which has both an amplitude shift between two amplitudes of which at least one is adjustable, and on the presence of at least one of the amplitudes a frequency shift between at least two adjustable frequencies. This can further be advantageous if for example a modulated signal can be generated which is to have a frequency shift between at least two adjustable frequencies, and on the presence of at least one of the frequencies an amplitude shift between at least two amplitudes, of which at least one is adjustable.

It may also be observed that the multiplicity of current conduction stages can be formed using transistors which can be grouped in relation to their conductivity properties.

In the above as an example of a device 1 according to the invention a remote control device was described. It is however expressly stated that the measures according to the invention can also be used in other devices which for example can constitute part of a higher device or system and serve to transmit any information, where data is transmitted using frequency shift and/or amplitude shift.

It may also be observed that for example it can be provided that the data signal DS has eight (8) bits and the adjustment data word selection means 43 as a function of data signal DS is designed to select one of two hundred and fifty-six (256) data words, where each of these data words has at least one bit more than the data signal DS so that in the present case two hundred and fifty-six (256) characteristic signal values can be adjusted.

## Claims

1. A circuit (2) to generate a modulated signal (S), with which circuit (2) modulation means (9; 59) can be implemented which are designed to receive a data signal (DS) and generate the modulated signal (S) as a function of the data signal (DS), where for the purpose of generating the modulated signal (S) as a function of the received data signal (DS) a choice can be made between at least two characteristic signal values (F1, F2) of the modulated signal (S), **characterized in that** adjustment means (13) are provided which are designed to adjust programmably and as a function of the data signal (DS) at least one of the characteristic signal values (F1, F2),
wherein the modulation means are constituted by frequency modulation means (9) to generate a frequency-modulated signal (S) forming the modulated signal and where the circuit (2) can form an oscillator stage (10) which is contained at least partly in the frequency modulation means (9) and is designed to generate the frequency-modulated signal (S) with modifiable frequency and which oscillator stage (10) has a capacitor configuration (11) designed to establish at least two frequencies (F1, F2) of the frequency-modulated signal (S), and which oscillator stage (10) has switch means (12) which are provided to switch the capacitor configuration (11) as a function of the data signal (DS) in order to select one of the at least two frequencies (F1, F2), wherein the adjustment means (13) are designed to adjust programmably and as a function of the data signal (DS) the at least two frequencies (F1, F2) of the frequency-modulated signal (S),
wherein the capacitor configuration (11) has a multiplicity of capacitors and wherein the switch means (12) have a multiplicity of switches where at least one capacitor is allocated to a switch and wherein the multiplicity of capacitors and the multiplicity of switches form components of the adjustment means (13) and wherein control means (49) are provided using which for the purpose of adjusting the at least two frequencies (F1, F2) of the frequency-modulated signal (S), the switches can be controlled programmably and as a function of the data signal (DS) in respect of their switching state,
wherein the control means (49) have a data source (44) provided to emit at least two adjustment data words (DW1, DW2) to influence the switch in respect of its switch state, and wherein the control means (49) have adjustment data word selection means (43) which are designed to select as a function of the data signal (DS) one of the at least two adjustment data words (DW1, DW2) which can be emitted by the data source (44),
wherein the data source (44) is implemented using at least two registers (45, 46), and
wherein each register (45, 46) is designed for temporary storage of an adjustment data word (DW1, DW2) for an operating period during which the circuit (2) is in active operating mode, and to emit the adjustment data word (DW1, DW2) to the adjustment data word selection means (43) during this operating period.

2. A circuit (2) as claimed in claim 1, **characterized in that** the control means (49) have a decoding stage (42) designed to receive an adjustment data word (DW1, DW2) and decode the received adjustment data word (DW1, DW2) and control the switch in respect of its switch state according to the decoded adjustment data word (DW1, DW2).

3. A circuit (2) as claimed in claim 2, **characterized in that** adjustment data storage means (47) are provided which are intended to store at least one adjustment data word (DW1, DW2).

4. A circuit (2) as claimed in claim 1, **characterized in that** the multiplicity of capacitors is sub-divided into at least two capacitor groups (14, 15, 16,17), and **in that** all capacitors of a capacitor group (14, 15, 16,17) are identical in capacitance.

5. A circuit (2) to generate a modulated signal (S), with which circuit (2) modulation means (9; 59) can be implemented which are designed to receive a data signal (DS) and generate the modulated signal (S) as a function of the data signal (DS), where for the purpose of generating the modulated signal (S) as a function of the received data signal (DS) a choice can be made between at least two characteristic signal values (A1, A2, A3, A4) of the modulated signal (S), **characterized in that** adjustment means (13) are provided which are designed to adjust programmably and as a function of the data signal (DS) at least one of the characteristic signal values (A1, A2, A3, A4),
wherein the modulation means are constituted by amplitude modulation means (59) to generate an amplitude-modulated signal (S) forming the modulated signal utilizing a carrier signal (CS) and where the circuit (2) can constitute amplitude definition means (60) which are contained at least partly in the amplitude modulation means (59) and are intended to define at least two amplitudes (A1, A2, A3, A4) of the amplitude-modulated signal (S), which amplitude modulation means (59) have controllable current conduction means (61) which are provided to influence as a function of the data signal (DS) the amplitude definition means (60) to select at least one of the at least two amplitudes (A1, A2, A3, A4), wherein the adjustment means (13) are designed to adjust programmably and as a function of the data signal (DS) at least one amplitude (A1, A2) of the amplitude-modulated signal (S), wherein the amplitude definition means (60) are implemented using controllable current conduction means (61),
wherein the controllable current conduction means (61) have a multiplicity of current conduction stages (63, 64, 65,66) where a current (11, 12, 13, 14) is allocated to each current conduction stage (63, 64, 65,66) in its conduction state, and wherein the multiplicity of current conduction stages (63, 64, 65,66) form elements of the adjustment means (13), and wherein control means (49) are provided using which for the purpose of adjusting the at least one amplitude (A1, A2, A3, A4) of the amplitude-modulated signal (S) the current conduction stages (63, 64, 65, 66) can be controlled programmably and as a function of the data signal (DS) in relation to their conduction state, and wherein the control means (49) have a data source (44) provided to emit at least two adjustment data words (DW1, DW2; DW1, DW2, DW3, DW4) to influence the current conduction stages (63, 64, 65, 66) in respect of their conduction state, and wherein the control means (49) have adjustment data word selection means (43) which are designed to select as a function of the data signal (DS) one of the at least two adjustment data words (DW1, DW2; DW1, DW2, DW3, DW4) which can be emitted by the data source (44),
wherein the data source (44) is implemented using at least two registers (45, 46, 72, 73), and
wherein each register (45, 46, 72, 73) is designed for temporary storage of an adjustment data word (DW1, DW2; DW1, DW2, DW3, DW4) for an operating period during which the circuit (2) is in active operating mode, and to emit the adjustment data word (DW1, DW2; DW1, DW2, DW3, DW4) to the adjustment data word selection means (43) during this operating period.

6. A circuit (2) as claimed in claim 5, **characterized in that** the control means (49) have a decoder stage (42) designed to receive an adjustment data word (DW1, DW2; DW1, DW2, DW3, DW4) and decode the adjustment data word received (DW1, DW2; DW1, DW2, DW3, DW4) and control the current conduction stages (63,64, 65,66) in respect of their conduction state in accordance with the decoded adjustment data word (DW1, DW2; DW1, DW2, DW3, DW4).

7. A circuit (2) as claimed in claim 5, **characterized in that** adjustment data storage means (47) are provided which are intended to store at least one adjustment data word (DW1, DW2; DW1, DW2, DW3, DW4).

8. A circuit (2) as claimed in claim 5, **characterized in that** the multiplicity of current conduction stages (63, 64, 65,66) are formed by means of transistors with different conduction properties.

9. A circuit (2) as claimed in claim 5, **characterized in that** the control means (49) have carrier signal transfer means (67) designed to transfer the carrier signal (CS) to the current conduction stages (63, 64, 65, 66) and using which the current conduction stages (63, 64, 65, 66) are also controllable as a function of the carrier signal (CS) with respect to their conduction state.

10. A circuit (2) as claimed in claim 9, **characterized in that** voltage supply generating means (74) for the transfer means are provided which are designed to generate, utilizing the carrier signal (CS), a voltage supply (VC) for the carrier signal transfer means (67).

11. A circuit (2) as claimed in claim 1, **characterized in that** the circuit (2) is formed as an integrated circuit.

12. A device (1) with a circuit (2) as claimed in any one of claims 1 to 4 and 11, wherein the circuit (2) is provided for generating the modulated signal (S), wherein the modulation means (9; 59) are implemented with the circuit (2), and wherein the circuit (2) forms the oscillator stage (10).

13. A device (1) with a circuit (2) as claimed in any one of claims 5 to 10, wherein the circuit (2) is provided for generating the modulated signal (S), wherein the modulation means (9; 59) are implemented with the circuit (2), and wherein the circuit (2) constitutes the amplitude definition means (60).

## Patentansprüche

1. Eine Schaltung (2) zum Erzeugen eines modulierten Signals (S), wobei mit der Schaltung (2) Modulationsmittel (9; 59) implementiert sein können, die so konzipiert sind, dass sie ein Datensignal (DS) empfangen und das modulierte Signal (S) als eine Funktion des Datensignals (DS) erzeugen, wobei für den Zweck der Erzeugung des modulierten Signals (S) als eine Funktion des empfangenen Datensignals (DS) eine Auswahl zwischen mindestens zwei charakteristischen Signalwerten (F1, F2) des modulierten Signals (S) getroffen werden kann, **dadurch gekennzeichnet, dass** Einstellmittel (13) vorgesehen sind, die so konzipiert sind, dass sie mindestens einen der charakteristischen Signalwerte (F1, F2) programmierbar und als eine Funktion des Datensignals (DS) einstellen,
wobei die Modulationsmittel durch Frequenzmodulationsmittel (9) gebildet werden, um ein frequenzmoduliertes Signal (S) zu erzeugen, welches das modulierte Signal ausbildet, und wobei die Schaltung (2) eine Oszillatorstufe (10) ausbilden kann, die zumindest teilweise in den Frequenzmodulationsmitteln (9) enthalten ist und so konzipiert ist, dass sie das frequenzmodulierte Signal (S) mit veränderbarer Frequenz ausbildet, und
wobei die Oszillatorstufe (10) eine Kondensatorkonfiguration (11) aufweist, die so konzipiert ist, dass sie mindestens zwei Frequenzen (F1, F2) des frequenzmodulierten Signals (S) herstellt, und wobei die Oszillatorstufe (10) Schaltermittel (12) aufweist, die vorgesehen sind, um die Kondensatorkonfiguration (11) als eine Funktion des Datensignals (D S) zu schalten, um eine der mindestens zwei Frequenzen (F1, F2) auszuwählen, wobei die Einstellmittel (13) so konzipiert sind, dass sie die mindestens zwei Frequenzen (F1, F2) des frequenzmodulierten Signals (S) programmierbar und als eine Funktion des Datensignals (DS) einstellen,
wobei die Kondensatorkonfiguration (11) eine Vielzahl von Kondensatoren aufweist und wobei die Schaltermittel (12) eine Vielzahl von Schaltern aufweisen, wobei mindestens ein Kondensator einem Schalter zugeordnet ist und wobei die Vielzahl von Kondensatoren und die Vielzahl von Schaltern Komponenten der Einstellmittel (13) ausbilden und wobei Steuermittel (49) vorgesehen sind, durch deren Verwendung zum Zweck der Einstellung der mindestens zwei Frequenzen (F1, F2) des frequenzmodulierten Signals (S) die Schalter programmierbar und als eine Funktion des Datensignals (DS) in Bezug auf ihren Schaltungszustand gesteuert werden können,
wobei die Steuermittel (49) eine Datenquelle (44) aufweisen, die vorgesehen ist, um mindestens zwei Einstellungsdatenwörter (DW1, DW2) auszusenden, um den Schalter in Bezug auf seinen Schalterzustand zu beeinflussen, und wobei die Steuermittel (49) Einstellungsdatenwortauswahlmittel (43) aufweisen, die so konzipiert sind, dass sie als eine Funktion des Datensignals (DS) eines der mindestens zwei Einstellungsdatenwörter (DW1, DW2), die von der Datenquelle (44) ausgesandt werden können, auswählen,
wobei die Datenquelle (44) unter Verwendung von mindestens zwei Registern (45, 46) implementiert ist und
wobei jedes Register (45, 46) für die temporäre Speicherung eines Einstellungsdatenworts (DW1, DW2) für einen Betriebszeitraum, während dem sich die Schaltung (2) in einem aktiven Betriebsmodus befindet, und zum Aussenden des Einstellungsdatenworts (DW1, DW2) an die Einstellungsdatenwortauswahlmittel (43) während dieses Betriebszeitraums konzipiert ist.

2. Eine Schaltung (2) nach Anspruch 1, **dadurch gekennzeichnet, dass** die Steuermittel (49) eine Decodierungsstufe (42) aufweisen, die so konzipiert ist, dass sie ein Einstellungsdatenwort (DW1, DW2) empfängt und das empfangene Einstellungsdatenwort (DW1, DW2) decodiert und den Schalter in Bezug auf seinen Schalterzustand gemäß dem decodierten Einstellungsdatenwort (DW1, DW2) steuert.

3. Eine Schaltung (2) nach Anspruch 2, **dadurch gekennzeichnet, dass** Einstellungsdatenspeichermittel (47) vorgesehen sind, die dazu dienen, mindestens ein Einstellungsdatenwort (DW1, DW2) zu speichern.

4. Eine Schaltung (2) nach Anspruch 1, **dadurch gekennzeichnet, dass** die Vielzahl von Kondensatoren in mindestens zwei Kondensatorgruppen (14, 15, 16, 17) unterteilt ist und dass alle Kondensatoren einer Kondensatorgruppe (14, 15, 16, 17) die gleiche Kapazität aufweisen.

5. Eine Schaltung (2) zum Erzeugen eines modulierten Signals (S), wobei mit der Schaltung (2) Modulationsmittel (9; 59) implementiert sein können, die so konzipiert sind, dass sie ein Datensignal (DS) empfangen und das modulierte Signal (S) als eine Funktion des Datensignals (DS) erzeugen, wobei für den Zweck der Erzeugung des modulierten Signals (S) als eine Funktion des empfangenen Datensignals (DS) eine Auswahl zwischen mindestens zwei charakteristischen Signalwerten (A1, A2, A3, A4) des modulierten Signals (S) getroffen werden kann, **dadurch gekennzeichnet, dass** Einstellmittel (13) vorgesehen sind, die so konzipiert sind, dass sie mindestens einen der charakteristischen Signalwerte (A1, A2, A3, A4) programmierbar und als eine Funktion des Datensignals (DS) einstellen,
wobei die Modulationsmittel durch Amplitudenmodulationsmittel (59) gebildet werden, um unter Nutzung eines Trägersignals (CS) ein amplitudenmoduliertes Signal (S) zu erzeugen, welches das modulierte Signal bildet, und wobei die Schaltung (2) Amplitudendefinitionsmittel (60) bilden kann, die zumindest teilweise in den Amplitudenmodulationsmitteln (59) enthalten sind und dazu dienen, mindestens zwei Amplituden (A1, A2, A3, A4) des amplitudenmodulierten Signals (S) zu definieren, wobei die Amplitudenmodulationsmittel (59) steuerbare Stromleitungsmittel (61) aufweisen, die vorgesehen sind, um als eine Funktion des Datensignals (DS) die Amplitudendefinitionsmittel (60) zu beeinflussen, um mindestens eine der mindestens zwei Amplituden (A1, A2, A3, A4) auszuwählen, wobei die Einstellmittel (13) so konzipiert sind, dass sie mindestens eine Amplitude (A1, A2) des amplitudenmodulierten Signals (S) programmierbar und als eine Funktion des Datensignals (DS) einstellen, wobei die Amplitudendefinitionsmittel (60) unter Verwendung steuerbarer Stromleitungsmittel (61) implementiert sind,
wobei die steuerbaren Stromleitungsmittel (61) eine Vielzahl von Stromleitungsstufen (63,64,65, 66) aufweisen, wobei jeder Stromleitungsstufe (63,64,65, 66) in ihrem Leitungszustand ein Strom (11, 12, 13, 14) zugeordnet ist und wobei die Vielzahl von Stromleitungsstufen (63, 64, 65, 66) Elemente der Einstellmittel (13) ausbildet und wobei Steuermittel (49) vorgesehen sind, durch deren Verwendung zum Zweck der Einstellung der mindestens einen Amplitude (A1, A2, A3, A4) des amplitudenmodulierten Signals (S) die Stromleitungsstufen (63, 64, 65, 66) programmierbar und als eine Funktion des Datensignals (DS) in Bezug auf ihren Leitungszustand gesteuert werden können, und wobei die Steuermittel (49) eine Datenquelle (44) aufweisen, die vorgesehen ist, um mindestens zwei Einstellungsdatenwörter (DW1, DW2; DW1, DW2, DW3, DW4) auszusenden, um die Stromleitungsstufen (63, 64, 65, 66) in Bezug auf ihren Leitungszustand zu beeinflussen, und wobei die Steuermittel (49) Einstellungsdatenwortauswahlmittel (43) aufweisen, die so konzipiert sind, dass sie als eine Funktion des Datensignals (DS) eines der mindestens zwei Einstellungsdatenwörter (DW1, DW2; DW1, DW2, DW3, DW4), die von der Datenquelle (44) ausgesandt werden können, auswählen,
wobei die Datenquelle (44) unter Verwendung von mindestens zwei Registern (45, 46, 72, 73) implementiert ist und
wobei jedes Register (45, 46, 72, 73) für die temporäre Speicherung eines Einstellungsdatenworts (DW1, DW2; DW1, DW2, DW3, DW4) für einen Betriebszeitraum, während dem sich die Schaltung (2) in einem aktiven Betriebsmodus befindet, und zum Aussenden des Einstellungsdatenworts (DW1, DW2; DW1, DW2, DW3, DW4) an die Einstellungsdatenwortauswahlmittel (43) während dieses Betriebszeitraums konzipiert ist.

6. Eine Schaltung (2) nach Anspruch 5, **dadurch gekennzeichnet, dass** die Steuermittel (49) eine Decoderstufe (42) aufweisen, die so konzipiert ist, dass sie ein Einstellungsdatenwort (DW1, DW2; DW1, DW2, DW3, DW4) empfängt und das empfangene Einstellungsdatenwort (DW1, DW2; DW1, DW2, DW3, DW4) decodiert und die Stromleitungsstufen (63, 64, 65, 66) in Bezug auf ihren Leitungszustand gemäß dem decodierten Einstellungsdatenwort (DW1, DW2; DW1, DW2, DW3, DW4) steuert.

7. Eine Schaltung (2) nach Anspruch 5, **dadurch gekennzeichnet, dass** Einstellungsdatenspeichermittel (47) vorgesehen sind, die dazu dienen, mindestens ein Einstellungsdatenwort (DW1, DW2; DW1, DW2, DW3, DW4) zu speichern.

8. Eine Schaltung (2) nach Anspruch 5, **dadurch gekennzeichnet, dass** die Vielzahl von Stromleitungsstufen (63, 64, 65, 66) mithilfe von Transistoren mit verschiedenen Leitungseigenschaften ausgebildet wird.

9. Eine Schaltung (2) nach Anspruch 5, **dadurch gekennzeichnet, dass** die Steuermittel (49) Trägersignaltransfermittel (67) aufweisen, die so konzipiert sind, dass sie das Trägersignal (CS) zu den Stromleitungsstufen (63, 64, 65, 66) transferieren, und durch deren Verwendung die Stromleitungsstufen (63, 64, 65, 66) auch als eine Funktion des Trägersignals (CS) in Bezug auf ihren Leitungszustand steuerbar sind.

10. Eine Schaltung (2) nach Anspruch 9, **dadurch gekennzeichnet, dass** Spannungsversorgungserzeugungsmittel (74) für die Transfermittel vorgesehen sind, die so konzipiert sind, dass sie unter Nutzung des Trägersignals (CS) eine Spannungsversorgung (VC) für die Trägersignaltransfermittel (67) erzeugen.

11. Eine Schaltung (2) nach Anspruch 1, **dadurch gekennzeichnet, dass** die Schaltung (2) als integrierte Schaltung ausgebildet ist.

12. Eine Vorrichtung (1) mit einer Schaltung (2) nach einem der Ansprüche 1 bis 4 und 11, wobei die Schaltung (2) zur Erzeugung des modulierten Signals (S) vorgesehen ist, wobei die Modulationsmittel (9; 59) mit der Schaltung (2) implementiert sind und wobei die Schaltung (2) die Oszillatorstufe (10) ausbildet.

13. Eine Vorrichtung (1) mit einer Schaltung (2) nach einem der Ansprüche 5 bis 10, wobei die Schaltung (2) zur Erzeugung des modulierten Signals (S) vorgesehen ist, wobei die Modulationsmittel (9; 59) mit der Schaltung (2) implementiert sind und wobei die Schaltung (2) die Amplitudendefinitionsmittel (60) bildet.

## Revendications

1. Circuit (2) pour générer un signal modulé (S), dans lequel circuit (2) peuvent être mis en oeuvre des moyens de modulation (9 ; 59) qui sont conçus pour recevoir un signal de données (DS) et générer le signal modulé (S) en fonction du signal de données (DS), dans lequel pour générer le signal modulé (S) en fonction du signal de données reçu (DS), on peut faire le choix entre au moins deux valeurs caractéristiques de signal (F1, F2) du signal modulé (S), **caractérisé par le fait que** sont prévus des moyens d'ajustement (13) qui sont conçus pour ajuster de manière programmable et en fonction du signal de données (DS) au moins une des valeurs caractéristiques du signal (F1, F2),
dans lequel les moyens de modulation sont constitués par des moyens de modulation en fréquence (9) pour générer un signal modulé en fréquence (S) formant le signal modulé et dans lequel le circuit (2) peut former un étage oscillateur (10) qui est contenu au moins en partie dans les moyens de modulation en fréquence (9) et est conçu pour générer le signal modulé en fréquence (S) avec une fréquence modifiable, et lequel étage oscillateur (10) a une configuration de condensateurs (11) conçue pour définir au moins deux fréquences (F1, F2) du signal modulé en fréquence (S), et lequel étage oscillateur (10) a des moyens de commutation (12) qui sont conçus pour commuter la configuration de condensateurs (11) en fonction du signal de données (DS) afin de sélectionner une fréquence parmi au moins deux fréquences (F1, F2), dans lequel les moyens d'ajustement (13) sont conçus pour ajuster de manière programmable et en fonction du signal de données (DS) au moins deux fréquences (F1, F2) du signal modulé en fréquence (S),
dans lequel la configuration de condensateurs (11) a une multiplicité de condensateurs et dans lequel les moyens de commutation (12) ont une multiplicité de commutateurs, dans lequel au moins un condensateur est affecté à un commutateur et dans lequel la multiplicité des condensateurs et la multiplicité des commutateurs forment les éléments des moyens d'ajustement (13), et dans lequel sont prévus des moyens de commande (49) utilisés dans le but d'ajuster au moins deux fréquences (F1, F2) du signal modulé en fréquence (S), les commutateurs pouvant être commandés de manière programmable et en fonction du signal de données (DS) pour ce qui concerne leur état de commutation,
dans lequel les moyens de commande (49) ont une source de données (44) conçue pour émettre au moins deux mots de données d'ajustement (DW1, DW2) pour influencer le commutateur du point de vue de son état de commutation, et dans lequel les moyens de commande (49) ont des moyens de sélection des mots de données d'ajustement (43) qui sont conçus pour sélectionner en fonction du signal de données (DS) un parmi au moins deux mots de données d'ajustement (DW1, DW2) qui peuvent être émis par la source de données (44),
dans lequel la source de données (44) est réalisée à l'aide d'au moins deux registres (45, 46), et
dans lequel chaque registre (45, 46) est conçu pour stocker temporairement un mot de données d'ajustement (DW1, DW2) pour une période de fonctionnement au cours de laquelle le circuit (2) est en mode de fonctionnement actif, et pour émettre le mot de données d'ajustement (DW1, DW2) vers les moyens de sélection de mot d'ajustement (43) au cours de cette période de fonctionnement.

2. Circuit (2) selon la revendication 1, **caractérisé par le fait que** les moyens de commande (49) ont un étage de décodage (42) conçu pour recevoir un mot de données d'ajustement (DW1, DW2) et décoder le mot de données d'ajustement reçu (DW1, DW2) et commander le commutateur pour ce qui concerne son état de commutation en fonction du mot de données d'ajustement décodé (DW1, DW2).

3. Circuit (2) selon la revendication 2, **caractérisé par le fait que** sont prévus des moyens de stockage de données d'ajustement (47) qui sont destinés à stocker au moins un mot de données d'ajustement (DW1, DW2).

4. Circuit (2) selon la revendication 1, **caractérisé par le fait que** la multiplicité de condensateurs est subdivisée en au moins deux groupes de condensateurs (14, 15, 16, 17), et que tous les condensateurs d'un groupe de condensateurs (14, 15, 16, 17) ont une capacité identique.

5. Circuit (2) pour générer un signal modulé (S), avec lequel circuit (2) peuvent être mis en oeuvre des moyens de modulation (9 ; 59) qui sont conçus pour recevoir un signal de données (DS) et générer le signal modulé (S) en fonction du signal de données (DS), dans lequel, pour générer le signal modulé (S) en fonction du signal de données reçu (DS), on peut faire un choix entre au moins deux valeurs caractéristiques de signal (A1, A2, A3, A4) du signal modulé (S), **caractérisé par le fait que** sont prévus des moyens d'ajustement (13) qui sont conçus pour ajuster de manière programmable et en fonction du signal de données (DS) au moins une des valeurs caractéristiques du signal (A1, A2, A3, A4),
dans lequel les moyens de modulation sont constitués par des moyens de modulation d'amplitude (59) pour générer un signal modulé en amplitude (S) formant le signal modulé en utilisant un signal de porteuse (CS) et dans lequel le circuit (2) peut constituer des moyens de définition d'amplitude (60) qui sont contenus au moins en partie dans les moyens de modulation d'amplitude (59) et sont conçus pour définir au moins deux amplitudes (A1, A2, A3, A4) du signal modulé en amplitude (S), lesquels moyens de modulation d'amplitude (59) ont des moyens de conduction de courant commandable (61) qui sont conçus pour influencer en fonction du signal de données (DS) les moyens de définition d'amplitude (60) afin de sélectionner au moins une amplitude parmi au moins deux amplitudes (A1, A2, A3, A4), dans lequel les moyens d'ajustement (13) sont conçus pour ajuster de manière programmable et en fonction du signal de données (DS) au moins une amplitude (A1, A2) du signal modulé en amplitude (S), dans lequel les moyens de définition d'amplitude (60) sont mis en oeuvre grâce aux moyens de conduction de courant commandable (61),
dans lequel les moyens de conduction de courant commandable (61) ont une multiplicité d'étages de conduction de courant (63, 64, 65, 66) dans lesquels un courant (11, 12, 13, 14) est affecté à chacun des étages de conduction de courant (63, 64, 65, 66) dans leur état de conduction, et dans lequel la multiplicité d'étages de conduction de courant (63, 64, 65, 66) forme les éléments des moyens d'ajustement (13), et dans lequel sont prévus des moyens de commande (49) que l'on utilise dans le but d'ajuster au moins une amplitude (A1, A2, A3, A4) du signal modulé en amplitude (S), les étages de conduction de courant (63, 64, 65, 66) pouvant être commandés de manière programmable et en fonction du signal de données (DS) pour ce qui concerne leur état de conduction, et dans lequel les moyens de commande (49) ont une source de données (44) conçue pour émettre au moins deux mots de données d'ajustement (DW1, DW2 ; DW1, DW2, DW3, DW4) pour influencer les étages de conduction de courant (63, 64, 65, 66) du point de vue de leur état de conduction, et
dans lequel les moyens de commande (49) ont des moyens de sélection des mots de données d'ajustement (43) qui sont conçus pour sélectionner en fonction du signal de données (DS) un parmi au moins deux mots de données d'ajustement (DW1, DW2 ; DW1, DW2, DW3, DW4) qui peuvent être émis par la source de données (44),
dans lequel la source de données (44) est réalisée à l'aide d'au moins deux registres (45, 46, 72, 73), et
dans lequel chaque registre (45, 46, 72, 73) est conçu pour stocker temporairement un mot de données d'ajustement (DW1, DW2 ; DW1, DW2, DW3, DW4) pour une période de fonctionnement au cours de laquelle le circuit (2) est en mode de fonctionnement actif, et pour émettre le mot de données d'ajustement (DW1, DW2 ; DW1, DW2, DW3, DW4) vers les moyens de sélection de mot d'ajustement (43) au cours de cette période de fonctionnement.

6. Circuit (2) selon la revendication 5, **caractérisé par le fait que** les moyens de commande (49) ont un étage de décodage (42) conçu pour recevoir un mot de données d'ajustement (DW1, DW2 ; DW1, DW2, DW3, DW4) et décoder le mot de données d'ajustement reçu (DW1, DW2 ; DW1, DW2, DW3, DW4) et commander les étages de conduction de courant (63, 64, 65, 66) pour ce qui concerne leur état de conduction en fonction du mot de données d'ajustement décodé (DW1, DW2 ; DW1, DW2, DW3, DW4).

7. Circuit (2) selon la revendication 5, **caractérisé par le fait que** sont prévus des moyens de stockage de données d'ajustement (47) qui sont destinés à stocker au moins un mot de données d'ajustement (DW1, DW2 ; DW1, DW2, DW3, DW4).

8. Circuit (2) selon la revendication 5, **caractérisé par le fait que** la multiplicité d'étages de conduction de courant (63, 64, 65, 66) est formée de transistors ayant des propriétés de conduction différentes.

9. Circuit (2) selon la revendication 5, **caractérisé par le fait que** les moyens de commande (49) ont des moyens de transfert de signal (67) conçus pour transférer le signal de porteuse (CS) aux étages de conduction de courant (63, 64, 65, 66) et grâce auxquels les étages de conduction de courant (63, 64, 65, 66) sont également commandables en fonction du signal de porteuse (CS) pour ce qui concerne leur état de conduction.

10. Circuit (2) selon la revendication 9, **caractérisé par le fait que** sont prévus des moyens de génération de tension d'alimentation (74) pour les moyens de transfert qui sont conçus pour générer à partir du signal de porteuse (CS) une alimentation en tension (VC) pour les moyens de transfert de signal de porteuse (67).

11. Circuit (2) selon la revendication 1, **caractérisé par le fait que** le circuit (2) est sous la forme d'un circuit intégré.

12. Dispositif (1) avec un circuit (2) selon l'une quelconque des revendications 1 à 4 et 11, dans lequel le circuit (2) est prévu pour générer le signal modulé (S), dans lequel les moyens de modulation (9 ; 59) sont réalisés dans le circuit (2) et dans lequel le circuit (2) forme l'étage oscillateur (10).

13. Dispositif (1) avec un circuit (2) selon l'une quelconque des revendications 5 à 10, dans lequel le circuit (2) est prévu pour générer le signal modulé (S), dans lequel les moyens de modulation (9 ; 59) sont réalisés dans le circuit (2), et dans lequel le circuit (2) constitue les moyens de définition d'amplitude (60).
